# EUROPEAN PATENT SPECIFICATION

(11) **EP 2 207 872 B1**
(45) Date of publication and mention of the grant of the patent: **03.07.2013**
(21) Application number: 08844248.8
(22) Date of filing: 29.10.2008
(51) Int. Cl.: C11D 3/32, C11D 7/32, C11D 11/00, G03F 7/42, H01L 21/02

(54) **NOVEL NITRILE AND AMIDOXIME COMPOUNDS AND METHODS OF PREPARATION**
NEUE NITRIL- UND AMIDOXIMVERBINDUNGEN UND HERSTELLUNGSVERFAHREN
NOUVEAUX COMPOSÉS NITRILE ET AMIDOXIME ET LEURS PROCÉDÉS DE PRÉPARATION

(30) Priority: 29.10.2007 US 727; 14.08.2008 US 88817
(43) Date of publication of application: 21.07.2010
(73) Proprietor: EKC TECHNOLOGY, INC., Hayward, CA 94545-1163 (US)
(72) Inventor: LEE, Wai, Mun, Fremont CA 94539 (US)
(74) Representative: Matthews, Derek Peter
(86) International application number: PCT/US2008/012240
(87) International publication number: WO 2009/058277

(56) References cited:
- EP-A- 1 610 365
- WO-A-2004/099086
- US-A- 3 794 488

## Description

### FIELD OF THE INVENTION

The present invention relates to semiconductor processing compositions comprising amidoxime compounds. The present invention also relates to the preparation of nitrile compounds and their conversion into amidoxime compounds for semiconductor processing compositions.

### RELATED APPLICATIONS

The application claims priority to U.S. Provisional Application 61/000,727, entitled "Compositions comprising chelating agents containing amidoxime compounds" (filed October 29, 2007), and U.S. Provisional Application No. 61/088,817 entitled "Novel Nitrile and Amidoxime Compounds and Methods of Preparation" (filed August 14, 2008) both of which were subsequently published as US 2009/0111965.

### BACKGROUND OF THE INVENTION

In the standard manufacture of an integrated circuit, typically more than one hundred steps are carried out that involve wafer cleaning or surface preparation. These steps range from removing residues intentionally placed on the surface, such as a post-resist strip / ash residual removal step, to the preparation of a surface for subsequent processing, such as by removing native oxide at a surface, and to etching itself. As a result, a variety of methods to treat surface are required.

Most cleaning or surfaces preparation steps are carried out in the 'wet', in other words by treating a substrate with a liquid composition. Typically (but not always), the cleaning effect of an active species is increased with its concentration and therefore, in order to maximize the cleaning effect of the liquid composition, the concentration of the active species is ideally maximized. However, due to cost, environmental and safety concerns, cleaning and surface preparation is increasingly being carried out by using dilute compositions. In order to compensate for possible changes in the cleaning effect at lower concentrations, the cleaning or surface preparation may be aided by the use of some form a mechanical energy, such as megasonics or jet-spray processing.

Accordingly, there is a need for chemistries that can be used in both single-wafer and batch processing while addressing a variety of goals in the cleaning or surface preparation process.

One specific cleaning or surface preparation step is the removal of residues containing metallic species. The metallic species may be left on the surface of a substrate after, for example, Chemical Mechanical Processing. Typically, in order to remove these residues, a liquid composition comprising a complexing agent is used. The complexing agent attaches to a central metal species by coordination through a non-metal atom. The resulting complex can serve several functions. For example, if the complex is more soluble than the metal species by itself, it facilitates removal of the complex. Alternatively, if the complexed product is not soluble in solution, it becomes a passivating agent by forming an insoluble film on top of the metal surface.

One problem with current semiconductor processing agents is that they have a tendency not only to serve their intended function such as the removal of residues, but also to remove both metals and metal oxides, such as copper and copper oxide. This is especially the case with acidic complexing agents. As a result, the selectivity of the action of the processing agents can be reduced. Accordingly, there is a need for semiconductor processing agents that are not aggressive toward metal substrates, while effectively serving their intended function, such as providing for the chelation of metal ion residues created during the manufacturing process.

Amidoximes are known for use in treatment solutions in the semiconductor industry, see for example WO 2004/084287 (re-published as EP-A-1 610 365) and WO 2004/099086.

### SUMMARY OF INVENTION

The present invention provides for compositions and kits suitable for use in semiconductor procession (*i.e.* residue removal, Chemical Mechanical Polishing (CMP) and resist stripping) comprising at least one compound containing two or more amidoximes. The present invention further provides a process for manufacturing a semiconductor device, the process comprising treating a substrate with a semiconductor processing composition as defined above. The present invention further provides the use of the semiconductor processing composition as defined above in semiconductor processing. The present invention further provides a process for preparing an amidoxime for a semiconductor processing composition, the process comprising: (a) mixing a cyanoethylation catalyst, a nucleophile and an *alpha-*unsaturated nitrile to produce a cyanoethylation product; and (b) converting a cyano group in the cyanoethylation product into an amidoxime.

One embodiment of the invention is a semiconductor processing composition comprising at least one compound containing two or more amidoxime functional groups. The semiconductor processing composition may be substantially free from metal irons and aqueous. Preferably, the semiconductor processing composition is used in semiconductor processing. In one embodiment of the invention, the semiconductor process composition is used in a process for manufacturing a semiconductor device which includes the step of treating a substrate with the semiconductor processing composition.

In another embodiment, the amidoxime in the composition is obtained by reaction of a nucleophile with an unsubstituted or substituted acrylonitrile and subsequent conversion of the CN group into an amidoxime. The conversion of the CN group into an amidoxime may be achieved by reaction with hydroxylamine that is not produced in the presence metal ions.

In yet another embodiment, the compound containing at least one amidoxime functional group in the semiconductor processing composition is selected from the group consisting of 1,2,3,4,5,6-hexakis-O-[3-(hydroxyamino)-3-iminopropyl Hexitol, 3,3',3",3"'-(ethane-1,2-diylbis(azanetriyl))tetrakis(N'-hydroxypropanimidamide), 3,3'-(ethane-1,2-diylbis(oxy))bis(N'-hydroxypropanimidamide), 3,3'-(piperazine-1,4-diyl)bis(N'-hydroxypropanimidamide), 3,3',3"-nitrilotris(N'-hydroxypropanimidamide), 3,3'-(2,2-bis((3-(hydroxyamino)-3-iminopropoxy)methyl)propane-1,3-diyl)bis(oxy)bis(N-hydroxypropanimidamide), 3,3'-(2,2'-(methylazanediyl)bis(ethane-2,1-diyl)bis(oxy))bis(N'-hydroxypropanimidamide), N,N-bis(3-amino-3-(hydroxyimino)propyl)acetamide, 3,3'-(2-(N'-hydroxycarbamimidoyl)phenylazanediyl)bis(N'-hydroxypropanimidamide), 3,3'-(2,2'-(3-amino-3-(hydroxyimino)propylazanediyl)bis(ethane-2,1-diyl))bis(oxy)bis(N'-hydroxypropanimidamide), 3,3'-azanediylbis(N'-hydroxypropanimidamide), N'1,N'6-dihydroxyadipimidamide, N'1,N'10-dihydroxydecanebis(imidamide), and mixures thereof.

Another embodiment of the invention is a method of preparing an amidoxime for a semiconductor processing composition. The method may have the steps of (a) mixing a cyanoethylation catalyst, a nucleophile and an *alpha*-unsaturated nitrile to produce a cyanoethylation product; and (b).converting at least one cyano group in the cyanoethylation product into an amidoxime functional group. In one embodiment, the catalyst does not contain metal ion. Exemplary catalysts include but are not limited to one or more organic ammonium hydroxide, preferably selected from the group consisting of benzyltrimethylammonium hydroxide, dimethyldiethylammonium hydroxide, tetrabutylammonium hydroxide, tetraethylammonium hydroxide, tetramethylammonium hydroxide, tetramethylammonium hydroxide pentahydrate, tetrapropylammonium hydroxide and trimethylbenzylammonium hydroxide. In some embodiments, the nucleophile contains oxygen and or nitrogen as the nucleophile centre. In one embodiment, the nucleophile is selected from -NR₁R₂ and -OH, wherein R₁ and R₂ are independently selected from alkyl, heteroalkyl, aryl and heteroaryl. The amidoxime may be formed by reaction of the cyano group in the cyanoethylation product with a source of hydroxylamine. In one embodiment, the amidoxime is formed by reaction of the cyano group in the cyanoethylation product with hydroxylamine that is not produced in the presence of metal ions.

Another embodiment of the invention is a process for treating a surface of a substrate in the manufacture of a semiconductor for electronic applications. The process comprises preparing an amidoxime according to the methods described above and applying the amidoxime to the surface of the substrate:

### DETAILED DESCRIPTION OF THE INVENTION

The present invention relates to a semiconductor processing composition for use in semiconductor processing.

Semiconductor processing compositions are well known in the art. A semiconductor processing composition is typically substantially free of metal ions. For example, the total concentration of metal ions can be about 100 ppm (parts per million) by weight or less, such as about 10 ppm by weight or less, for example about 1 ppm by weight or less, or as low as about 100 ppb (parts per billion) or less, for example about 10 ppb or less. This requires the composition to have been treated carefully in order to prevent contamination of the composition with metal ions. For example, if the composition comprises water, the water is preferably specifically prepared ultra-high purity water. In addition, if glassware that has not been carefully cleaned is used to prepare the composition, metal ions can leach into the composition from the glassware, thereby making the composition unsuitable for use as a semiconductor processing composition. Furthermore, if reagents comprising metal ions are used to manufacture or purify the components of the composition, the final composition is typically not substantially free of metal ions unless it has been carefully handled and treated. The viscosity and surface tension of semiconductor processing compositions can also be tailored according to its use.

Semiconductor processing refers generally to any step involved in the manufacture of an integrated circuit from a semiconductor substrate. Semiconductor processing includes residue removal, Chemical Mechanical Polishing (CMP) and resist stripping. Thus the semiconductor processing composition of the present invention can be used in, but is not limited to use in, residue removal resist stripping, post-CMP clean, and as an additive for CMP slurries.

In one embodiment, the present invention also provides a kit comprising a semiconductor processing composition for use in semiconductor processing and a semiconductor treatment apparatus. Semiconductor treatment apparatuses are well known in the art. The apparatus may, for example, be a Chemical Mechanical Polishing apparatus. Examples of semiconductor processing apparatuses are well known in the art. Semiconductor processing apparatus, for example, need to be kept in a highly clean environment, for example in a clean room environment, so that they are suitable for use in semiconductor processing.

The term "kit" refers to the combination of the semiconductor processing composition and the semiconductor processing apparatus. The kit may for example be provided to an end user as a single item or the kit may be provided as separate parts and combined at the point of use. If, for example, the kit comprises a Chemical Mechanical Polishing apparatus, the semiconductor processing composition may be intended for use either with the apparatus itself (for example as an additive in CMP) or in a step subsequent to (e.g. directly after) the treatment of a substrate with the apparatus (for example in a post-CMP cleaning step).

The semiconductor processing composition of the present invention, whether provided as a kit or by itself, comprises an amidoxime compound. For completeness, it is noted that the term *"compound"* includes within its scope, but is not limited to, small molecules (e.g. having a molecular weight of 1000 or below, for example 500 or below, such as 300 or below), oligomers and polymers.

The use of amidoxime compounds in semiconductor processing has already been described in US 61/000,727 (to Wai Mun Lee, entitled "Composition comprising Chelating agents containing Amidoxime Compounds", subsequently published as US 2009/0111965. This application shows that amidoxime compounds are effective in semiconductor processing and more specifically can be used in a composition for removal of metal residues from a substrate. The application also shows that amidoxime compounds are effective for use in a wide variety of semiconductor processing steps.

The semiconductor processing composition may comprise simply an amidoxime by itself or it may comprise other components. While it is contemplated that the amidoxime may be used in its gaseous form, usually the amidoxime will be provided in a liquid composition. Accordingly, the amidoxime may be dissolved or suspended in a solvent.

Other components may also be included in the composition. For example, acids may be included; bases may be included; activators may be included; hydroxylamines may be included; chelating agents may be included; surface passivation agents may be included; and surfactants may be included.

The solvent in the liquid composition may be water by itself. Alternatively, the solvent may be water with a co-solvent (*i.e.* a solvent that is miscible with water) or water with a separate immiscible solvent. Alternatively, the solvent may be water-free (e.g. having a water content of 10⁻³ moldm⁻³ or less). The amidoxime is preferably soluble in the solvent system used, although it can be provided in other forms, for example as a suspension. For example, the amidoxime may be water soluble.

The amidoxime molecules can comprise any number of amidoxime functional groups from two upwards.

A greater number of amidoxime groups in a single molecule is advantageous because it allows for multi-dentate binding. Multi-dentate binding is advantageous for a number of reasons, for example because multi-dentate ligands tend to have higher association constants than mono-dentate ligands. A higher association constant is useful in, for example, facilitating the removal of hard-to-remove residues from the surface.

In other embodiments, water and/or solvent soluble ligands are preferred.

The present invention further provides a process for producing a semiconductor device for electronic applications, the process comprising treating a substrate with a semiconductor processing composition of the present invention. In some embodiments, the total concentration of amidoximes in solution will be 1 moldm³ or less, for example 0.1 moldm³ or less. In other embodiments, higher concentrations of amidoximes will be used.

### The amidoxime functional group

The amidoxime functional group may have the following chemical formula: 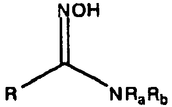 or salts or tautomers thereof. Firstly considering the amidoxime functional group itself, in one embodiment, both Rₐ and R_{b} are hydrogen. In another embodiment, Rₐ and R_{b} are independently hydrogen, alkyl, hetero-alkyl, alkyl-aryl, or alkyl-heteroaryl groups. R is independently selected from alkyl, alkyl-aryl, or alkyl-heteroaryl groups. In these two embodiments, chelation of the amidoxime to metal centres may be favoured because, in reaction with a metal centre, a proton can be lost from NRₐR_{b} so as to form a nominally covalent bond with the metal centre. In another embodiment, NRₐR_{b} is further substituted with R_{c} so the amidoxime has the following chemical formula: 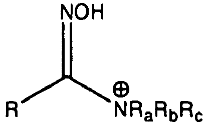 In this case, a counter-ion (X) balances the positive charge on the nitrogen atom. Any counter-ion may be used, for example chloride, bromide, iodide, a SO₄ ion, a PF₆ ion or a ClO₄ ion. R_{c} may be independently selected from hydrogen, alkyl, hetero-alkyl, alkyl-aryl, or alkyl-heteroaryl groups. The counter-ion may be singly charged, doubly charged or more highly charged.

It is noted that Rₐ, R_{b} and / or R_{c} can join onto one another and / or join onto R so as to form one or more cycles.

It is also noted that amidoxime can exist as tautomers: 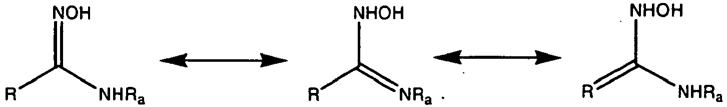 The third tautomer may or may not be accessible depending on the structure of the R group. Compounds that exist mainly or wholly in one or both of the tautomeric forms are included within the scope of the invention.

Accordingly, the amidoxime functional group includes the following functionalities and their tautomers: 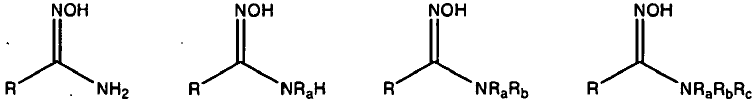 It is again noted that in some embodiments R may be connected to one or more of Rₐ, R_{b} and R_{c}.

For example, the amidoxime functional group includes within its scope: 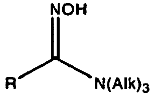 wherein Alk is an alkyl group as defined below. The three alkyl groups may be independently selected or may be the same. In one embodiment, the alkyl group is methyl or ethyl.

### The group appending the carbon centre of the amidoxime functional group

Turning now to the R group (the group directly joined to the carbon centre of the amidoxime group), R may contain any number of carbon atoms (including zero). While groups having a lesser number of carbon atoms tend to be more soluble in polar solvents such as DMSO and water (DMSO may also be used as a co-solvent with water), groups having a greater number of carbons can have other advantageous properties, for example surfactant properties. Therefore, in one embodiment, the R group contains 1 to 10 carbon atoms, for example 1 to 6 carbon atoms. In another embodiment, the R group contains 10 or more carbon atoms, for example 10 to 24 carbon atoms.

R may be an alkyl group (in other words, a group containing carbon and hydrogen). The alkyl group may be completely saturated or may contain unsaturated groups (*i.e*., may contain alkene and alkyne functional groups, so the term "alkyl" encompasses the terms "alkylene" and "alkylyne" within its scope). The alkyl group may be straight-chained or branched.

The alkyl group may be unsubstituted (*i.e.* the alkyl group contains only carbon and hydrogen). The unsubstituted alkyl group may be unsaturated or saturated. Examples of possible saturated unsubstituted alkyl groups include methyl, ethyl, *n-*propyl, *sec*-propyl, cyclopropyl, *n*-butyl, *sec*-butyl, *tert*-butyl, cyclobutyl, pentyl (branched or unbranched), hexyl (branched or unbranched), heptyl (branched or unbranched), octyl (branched or unbranched), nonyl (branched or unbranched), and decyl (branched or unbranched). Saturated unsubstituted alkyl groups having a greater number of carbons may also be used. Cyclic alkyl groups may also be used, so the alkyl group may comprise, for example, a cyclopropyl group, a cyclcobutyl group, a cyclopentyl group, a cyclohexyl group, a cycloheptyl group, a cyclooctyl group, a cyclcononyl group and / or a cyclodecyl group. These cyclic alkyl groups may directly append the amidoxime group or may be joined to the amidoxime through one or more carbon atoms.

For example, the amidoxime may be: 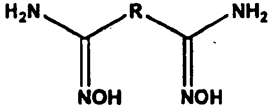 where R is an alkylene group. For example, R may be a straight chained alkylene group, such as an unsubstituted straight chained alkylene group. Examples of suitable groups include methylene, ethylene, propylene, butylene, pentylene, hexylene, heptylene, octylene, nonylene and decylene.

If the alkyl group is unsaturated, it may be any of the alkyl groups previously listed except for having one or more unsaturated carbon-carbon bonds (so it may contain one or more alkene and / or alkyne groups). These unsaturated group(s) may optionally be in conjugation with the amidoxime group.

The alkyl group may also be substituted with one or more hetero-atoms or group of hetero-atoms. If more than one hetero-substituent is present, the substituents are independently selected from one another unless they form a part of a particular functional group (e.g. an amide group). Groups containing hetero-atoms joined to carbon atoms are contained within the scope of the term *"heteroalklyl"* as discussed below. One or more of the substituents may be a halogen atom, including fluorine, chlorine, bromine or iodine, -OH, =O, -NH₂, =NH, -NHOH, =NOH, -OPO(OH)₂, -SH, =S or -SO₂OH. In one embodiment, the substituent is an oxime group (=NOH). The alkyl group may also be itself substituted with one or more amidoxime functional groups.

If the alkyl group is substituted with =O, the alkyl group may comprise an aldehyde, a ketone, a carboxylic acid or an amide. Preferably, there is an enolizable hydrogen adjacent to the =O, =NH or =NOH (*i.e*. there is a hydrogen in the *alpha* position to the carbonyl). The alkyl group may comprise the following functionality: - (CZ₁)-CH-(CZ₂)-, wherein Z₁ and Z₂ are independently selected from O, NH and NOH. The CH in this group is further substituted with hydrogen or an alkyl group or joined to the amidoxime functional group.

Thus, an alkyl group appending an amidoxime group may simply be substituted with, for example one or more independently-selected halogens, for example fluorine, chlorine, bromine or iodine. In one embodiment, the halogens are substituted at the antipodal (*i.e*. opposite) end of the alkyl group to the amidoxime group. This can for example provide surfactant activity, in particular for example if the halogen is fluorine.

Compounds that are substituted in a *β* position are conveniently synthesized from readily-available starting materials.

Examples of such compounds include, but are not limited to: 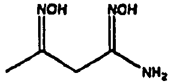 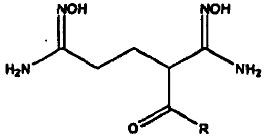 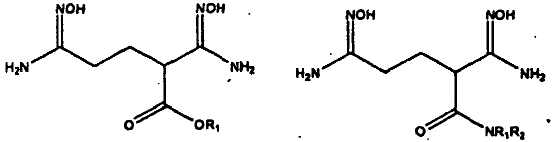 wherein R₁ and R₂ are independently-selected alkyl groups or hydrogen atoms.

It should be noted that some of these molecules can exist as different isomers.

R may be a heteroalkyl group. The term heteroalkyl refers to optionally a first alkyl group connected to one or more independently-selected hetero-atoms or groups of hetero-atoms, which itself is substituted with one or more independently-selected groups containing one or more carbon atoms. The presence of the first alkyl group is optional because the amidoxime group may be attached directly to the one or more heteroatoms. As an illustrative example, an alkyl group substituted with an ether group is a heteroalkyl group because the alkyl group is substituted with oxygen, which itself is substituted with a second alkyl group. Alternatively, an -O-CH₃ group is an example of a heteroalkyl group.

When R is a heteroalkyl group, the amidoxime may have the following chemical structure: 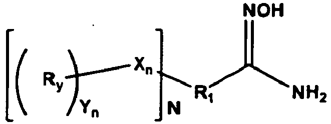 where "n" varies from 1 to N and y varies from 1 to Yₙ; N varies from 0 to 3; Yₙ varies from 0 to 5. In this formula, R₁ is independently-selected alkylene groups; Ry is independently selected from alkyl, or hetero-alkyl groups, or adjoins R₁ so to form a heterocycle with the directly appending Xₙ. R₁ may also be a direct bond, so that the amidoxime group is connected directly to the one or more heteroatoms. Xₙ is a heteroatom or a group of heteroatoms selected from boron, nitrogen, oxygen, silicon, phosphorus and sulphur. Each heteroatom or group of heteroatoms and each alkyl group is independently selected from one another. The above formula includes an amidoxime group directly bearing an alkyl group. The alkyl group is substituted with N independently-selected heteroatoms or groups of heteroatoms. Each heteroatom or group of heteroatoms is itself substituted with one or more independently-selected alkyl groups or hetero-alkyl groups.

X is one or more hetero-atoms. For example, X may be or may comprise boron, nitrogen, oxygen, silicon, phosphorus or sulphur. In one embodiment, X is oxygen. In this case, X may be part of an ether group (-O-), an ester (-O-CO-), -O-CO-O-, -O-CO-NH-, -O-CO-NR₂-, -O-CNH-, -O-CNH-O-, -O-CNH-NH-, -O-CNH-NR₂-, -O-CNOH-, - O-CNOH-O-, -O-CNOH-NH- or -O-CNOH-NR₂-, wherein R₂ is independently selected alkyl group, hetero-alkyl group, or hetero-aryl group. In another embodiment, X is a nitrogen atom. In this case, X may be part of one of the following groups: -NR₂H, -NR₂-,-NR₂R₃- (with an appropriate counter-ion), -NHNH-, -NH-CO-, -NR2-CO-, -NH-COO-, -NH-CO-NH-, -NH-CO-NR₂-, -NR₂-CO-NH-, -NR₂-CO-NR₃-, -NH-CNH-, -NR2-CNH-, -NH-CNH-O-, -NH-CNH-NH-, -NH-CNH-NR₂-, -NR₂-CNH-NH-, -NR₂-CNH-NR₃-, -NH-CNOH-, -NR2-CNOH-, -NH-CNOH-O-, -NH-CNOH-NH-, -NH-CNOH-NR₂-, -NR₂-CNOH-NH-, -NR₂-CNOH-NR₃-. R₂ to R₃ are independently selected alkyl groups, hetero-alkyl groups, or hetero-aryl groups, wherein the heteroalkyl group and hetero-aryl group may be unsubstituted or substituted with one or more heteroatoms or group of heteroatoms or itself be substituted with another heteroalkyl group. If more than one hetero-substituent is present, the substituents are independently selected from one another unless they form a part of a particular functional group *(e.g.,* an amide group).

In another embodiment, X comprises boron. In this case, X may also comprise oxygen. In another embodiment, X comprises phosphorus. In this case, X may also comprise oxygen, for example in an -OPO(OH)(OR₂) group or an -OPO(OR₂)(OR₃) group. In another embodiment, X comprises sulphur, for example as a thiol ether or as a sulphone.

The term heteroalkyl also includes within its scope cyclic alkyl groups containing a heteroatom. If X is N or O, examples of such groups include a lactone, lactam or lactim. Further examples of heteroalkyl groups include azetidines, oxetane, thietane, dithietane, dihydrofuran, tetrahydrofuran, dihydrothiophene, tetrahydrothiophene, piperidine, pyroline, pyrolidine, tetrahydropyran, dihydropyran, thiane, piperazine, oxazine, dithiane, dioxane and morpholine. These cyclic groups may be directly joined to the amidoxime group or may be joined to the amidoxime group through an alkyl group.

The heteroalkyl group may be unsubstituted or substituted with one or more hetero-atoms or group of hetero-atoms or itself be substituted with another heteroalkyl group. If more than one hetero-substituent is present, the substituents are independently selected from one another unless they form a part of a particular functional group (*e.g*. an amide group). One or more of the substituents may be a halogen atom, including fluorine, chlorine, bromine or iodine, -OH, =O, -NH₂, =NH, -NHOH, =NOH, - OPO(OH)₂, -SH, =S or -SO₂OH. In one embodiment, the substituent is an oxime group (=NOH). The heteroalkyl group may also be itself substituted with one or more amidoxime functional groups.

If the heteroalkyl group is substituted with =O, the heteroalkyl group may comprise an aldehyde, a ketone, a carboxylic acid or an amide. Preferably, there is an enolizable hydrogen adjacent to the =O, =NH or =NOH *(i.e.* there is a hydrogen in the *alpha* position to the carbonyl). The heteroalkyl group may comprise the following functionality: -(CZ₁)-CH-(CZ₂)-, wherein Z₁ and Z₂ are independently selected from O, NH and NOH. The CH in this group is further substituted with hydrogen or an alkyl group or heteroalkyl group orjoined to the amidoxime functional group.

Amines are particularly versatile functional groups for use in the present invention, in part because of their ease of preparation. For example, by using acrylonitrile as described later, a variety of functionalized amines can be synthesized.

Examples include, but are not limited to: 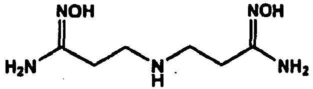 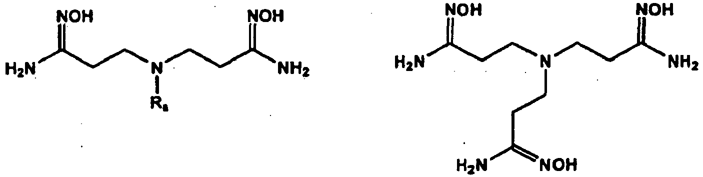 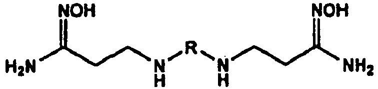 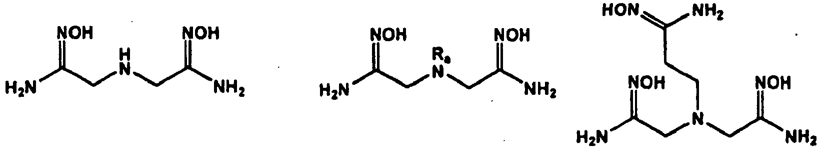 wherein Rₐ and R_{b} are independently-selected hydrogen, alkyl, hetero-alkyl, aryl, hetero-aryl, alkyl-aryl, or alkyl-heteroaryl groups.

R may itself be an alkylene group or a heteroatom or group of heteroatoms. The heteroatoms may be unsubstituted or substituted with one or more alkyl groups. For example, R may be H, NH₂, NHR₁, OR₁ or NR₁R₂, wherein R₁ and R₂ are independently-selected alkyl groups.

R may be an aryl group. The term *"aryl"* refers to a group comprising an aromatic cycle. The cycle is made from carbon atoms. The cycle itself may contain any number of atoms, for example 3 to 10 atoms. For the sake of convenient synthesis, cycles comprising 5 or 6 atoms have been found to be particularly useful. An example of an aryl substituent is a phenyl group.

The aryl group may be unsubstituted. A specific example of an amidoxime bearing an unsubstituted aryl is:

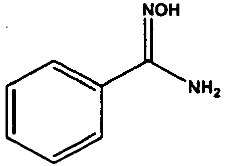

The aryl group may also be substituted with one or more alkyl groups, heteroalkyl groups, or hetero-atom substituents. If more than one substituent is present, the substituents are independently selected from one another.

One or more of the hetero-atom substituents may be for example, a halogen atom, including fluorine, chlorine, bromine or iodine, -OH, =O, -NH₂, =NH, -NHOH, =NOH, -OPO(OH)₂, -SH, =S or -SO₂OH. In one embodiment, the substituent is an oxime group (=NOH). The one or more alkyl groups are the alkyl groups defined previously and the one or more heteroalkyl groups are the heteroalkyl groups defined previously.

R may also be hetero-aryl. The term hetero-aryl refers to an aryl group containing one or more hetero-atoms in its aromatic cycle. The one or more hetero-atoms are independently-selected from, for example, boron, nitrogen, oxygen, silicon, phosphorus, and sulfur. Examples of hetero-aryl groups include pyrrole, furan, thiophene, pyridine, melamine, pyran, thiine, diazine and thiazine. The hetero-atom(s) in these cycles may themselves be substituted, for example the amidoxime may comprise pyridine *N*-oxide.

The hetero-aryl group may be unsubstituted. The hetero-aryl group may also be substituted.

It should be noted that the heteroaryl group may be attached to the amidoxime group through its heteroatom, for example. The hetero-aryl group may be substituted with one or more alkyl groups, heteroalkyl groups or hetero-atom substituents. If more than one substituent is present, the substituents are independently selected from one another.

One or more of the hetero-atom substituents may be, for example, a halogen atom, including fluorine, chlorine, bromine or iodine, -OH, =O, -NH₂, =NH, -NHOH, =NOH, -OPO(OH)₂, -SH, =S or -SO₂OH. The one or more alkyl groups are the alkyl groups defined previously and the one or more heteroalkyl groups are the heteroalkyl groups defined previously.

Within the scope of the term aryl are alkyl-aryl groups. The term *"alkyl-aryl"* refers to an amidoxime group bearing (*i.e.* directly joined to) an alkyl group. The alkyl group is then itself substituted with an aryl group. Correspondingly, within the scope of the term heteroaryl are alkyl-heteroaryl groups.

The alkyl group may be any alkyl group previously defined. The acryl /heteroaryl group may also be any aryl group previously defined.

Both the alkyl group and the aryl / heteroalkyl group may be unsubstituted.

Alternatively, one or both of the alkyl group and the aryl / heteroalkyl group may be substituted. If the alkyl group is substituted, it may be substituted with one or more hetero-atoms or groups containing hetero-atoms. If the aryl / heteroalkyl group is substituted, it may be substituted with one or more alkyl groups, heteroalkyl groups or hetero-atom substituents. If more than one substituent is present, the substituents are independently selected from one another.

One or more of the hetero-atom substituents may be, for example, a halogen atom, including fluorine, chlorine, bromine or iodine, -OH, =O, -NH₂, =NH, -NHOH, =NOH, -OPO(OH)₂, -SH, =S or -SO₂OH. In one embodiment, the substituent is an oxime group (=NOH). The alkyl group may also be itself substituted with one or more amidoxime functional groups.

If the alkyl group is substituted with =O, the alkyl group may comprise an aldehyde, a ketone, a carboxylic acid or an amide. Preferably, there is an enolizable hydrogen adjacent to the =O, =NH or =NOH *(i.e.* there is a hydrogen in the *alpha* position to the carbonyl). The alkyl group may comprise the following functionality: - (CZ₁)-CH-(CZ₂)-, wherein Z₁ and Z₂ are independently selected from O, NH and NOH. The CH in this group is further substituted with hydrogen or an alkyl group or heteroalkyl group or joined to the amidoxime functional group.

Within the scope of the term aryl are also heteroalkyl-aryl groups. The term *"heteroalkyl-aryl"* refers to an amidoxime group bearing (*i.e*. directly joined to) a heteroalkyl group. The heteroalkyl group is then itself substituted with an aryl group. Correspondingly, within the scope of the term heteroaryl are also heteroalkyl-aryl groups

The heteroalkyl group may be any alkyl group previously defined. The aryl /heteroaryl group may also be any aryl group previously defined.

Both the heteroalkyl group and the aryl / heteroaryl group may be unsubstituted. Alternatively, one or both of the heteroalkyl group and the aryl / heteroaryl group may be substituted. If the heteroalkyl group is substituted, it may be substituted with one or more hetero-atoms or groups containing hetero-atoms. If the aryl / heteroaryl group is substituted, it may be substituted with one or more alkyl groups, heteroalkyl groups or hetero-atom substituents. If more than one substituent is present, the substituents are independently selected from one another.

One or more of the hetero-atom substituents may be, for example, a halogen atom, including fluorine, chlorine, bromine or iodine, -OH, =O, -NH₂, =NH, -NHOH, =NOH, -OPO(OH)₂, -SH, =S or -SO₂OH. In one embodiment, the substituent is an oxime group (=NOH). The alkyl group may also be itself substituted with one or more amidoxime functional groups.

If the heteroalkyl group is substituted with =O, the heteroalkyl group may comprise an aldehyde, a ketone, a carboxylic acid or an amide. Preferably, there is an enolizable hydrogen adjacent to the =O, =NH or =NOH (*i.e.* there is a hydrogen in the *alpha* position to the carbonyl). The heteroalkyl group may comprise the following functionality: -(CZ₁)-CH-(CZ₂)-, wherein Z₁ and Z₂ are independently selected from O, NH and NOH. The CH in this group is further substituted with hydrogen or an alkyl group or heteroalkyl group or joined to the amidoxime functional group.

A preferred substituent to any type of R group is a tetra-valent nitrogen. In other words, any of the above groups may be substituted with -NRₐR_{b}R_{c} where Rₐ to R_{c} are independently-selected R groups as defined herein. In one embodiment, Rₐ to R_{c} are unsubstituted saturated alkyl groups having 1 to 6 carbon atoms. For example, one or more of (for example all of) Rₐ to R_{c} are methyl and / or ethyl. With this substituent, the tetra-valent nitrogen is preferably substituted in an antipodal position to the amidoxime group. For example, if R is a straight-chained unsubstituted saturated alkyl group of the form (CH₂)ₙ, then the tetra-valent nitrogen is at one end of the alkyl group and the amidoxime group is at the other end. In this embodiment, n is preferably 1, 2, 3, 4, 5 or 6.

The present invention provides an amidoxime molecule containing two or more amidoxime functional groups. In fact, a large number of functional groups can be contained in a single molecule, for example if a polymer has repeating units having appending amidoxime functional groups. Examples of amidoxime compounds that contain more than one amidoxime functional groups have been described previously throughout the specification.

Amidoximes may be conveniently prepared from nitrile-containing molecules as follows: 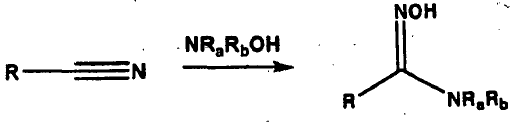 Typically, to prepare a molecule having Rₐ = R_{b} = H, hydroxylamine is used. If one or both of Rₐ and R_{b} in the desired amidoxime is not hydrogen, the amidoxime can be prepared either by using the corresponding hydroxylamine or by further reacting the amidoxime once it has been formed. This may, for example, occur by intra-molecular reaction of the amidoxime.

Accordingly, amidoxime molecules containing more than one amidoxime functional groups can be conveniently prepared from precursors having more than one nitrile group.

One preferred method of forming the nitrile precursors to the amidoximes of the present invention is by nucleophilic substitution of a leaving group with a nucleophile. Nucleophiles are well known to the person skilled in the art, *see* for example the Guidebook to Mechanism in Organic Chemistry by Peter Sykes. Examples of suitable nucleophiles are molecules having an OH, SH, NH- or a suitable CH- group, for example one having a low pKₐ (for example below about 15). For OH, SH and NH-, the hydrogen is optionally removed before acting as a nucleophile in order to augment its nucleophilicity. For CH-, they hydrogen is usually removed with a suitable base so that it can act as a nucleophile.

Leaving groups are well known to the person skilled in the art, *see* for example the Guidebook to Mechanism in Organic Chemistry by Peter Sykes. Examples of suitable leaving groups include Cl, Br, I, O-tosyl, O-mesolate and other leaving group well known to the person skilled in the art. The ability to act as a leaving group may be enhanced by adding an acid, either protic or Lewis.

For example, a nitrile can be formed accordingly:

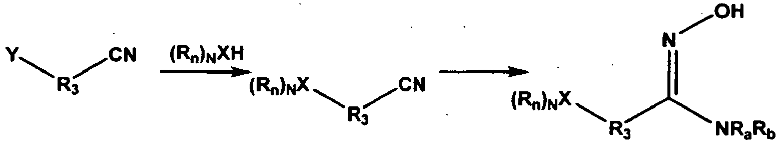

In this example, R₃ is independently selected from alkylene, heteroalkylene, arylene, heteroarylene, alkylene-heteroaryl, or alkylene-aryl group. Rₙ is independently selected from hydrogen, alkyl, heteroalkyl, aryl, heteroaryl, alkyl-heteroaryl, or alkyl-aryl group. X may be any a nucleophile selected from O, S, N, and suitable C. N varies from 1 to 3. Y is a leaving group.

For XH = OH, the OH may be an alcohol group or may, for example, be part of a hemiacetal or carboxylic acid group.

For X = NH-, the NH may be part of a primary or secondary amine (i.e. NH₂ or NHR₅), NH-CO-, NH-CNH-, NH-CHOH- or -NHNR₅R₆ (wherein R₅ and R₆ are independently-selected alkyl, heteroalkyl, aryl, heteroaryl or alkyl-aryl).

For XH = CH-, wherein a stabilized anion may be formed. XH may be selected from but not limited to -CHCO-R₅, -CHCOOH, -CHCN, -CHCO-OR₅, -CHCO-NR₅R₆, - CHCNH-R₅, -CHCNH-OR₅, -CHCNH-NR₅R₆, -CHCNOH-R₅, -CHCNOH-OR₅ and - CHCNOH-NR₅R₆.

A preferred example is: 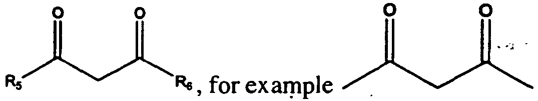 wherein R₅ and R₆ are independently-selected alkyl, heteroalkyl, aryl, heteroaryl or alkyl-aryl or a heteroatom optionally substituted with any of these groups. In one embodiment, either one or both of R₅ and R₆ are oxygen or nitrogen atoms optionally independently substituted with alkyl, heteroalkyl, aryl, heteroaryl or alkyl-aryl groups, for example:

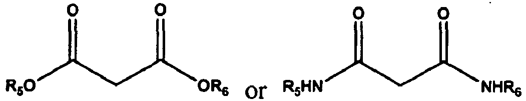

The compounds may also be formed by any type of nucleophilic reaction using any of the above nucleophiles.

It has been found that one reaction in particular is particularly versatile for producing nitrile precursors for amidoxime compounds: 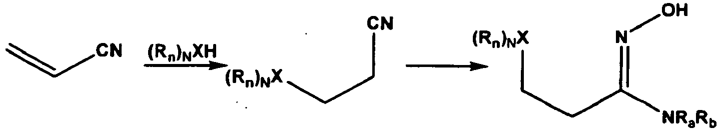 In this example, X bears N independently-selected substituents. Each Rₙ is independently chosen from hydrogen, alkyl, heteroalkyl, aryl, heteroaryl and alkylaryl as previously defined. X.is a nucleophile as previously defined. The acrylonitrile may be substituted as desired.

For example, the acrylonitrile may have the following formula: 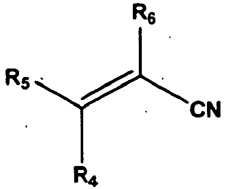 wherein R₄, R₅ and R₆ are independently selected from hydrogen, heteteroatoms (*i.e.* atoms or groups that are not carbon or hydrogen), heterogroups, alkyl, heteroalkyl, aryl and heteroaryl.

Accordingly, the present invention also relates to amidoxime compounds for use in semiconductor processing prepared by the addition of a nucleophile to an unsubstituted or substituted acrylonitrile. Once nucleophilic addition to the acrylonitrile has occurred, the intermediate can be functionalized using standard chemistry known to the person skilled in the art: 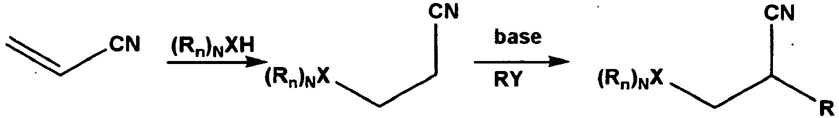 where Y is a leaving group as previously defined.

More particularly, the present invention relates to a process for preparing an amidoxime for a semiconductor processing composition, the process comprising: (a) mixing a nucleophile and an *alpha*-unsaturated nitrile to produce a cyanoethylation product; (b) converting at least one cyano group in the cyanoethylation product into an amidoxime functional group. This process is particularly suited for the preparation of an amidoxime for use in semiconductor processing because it can be adapted for producing amidoximes that are substantially free from metal ions. This process may further comprise the additional step of (c) applying the amidoxime to the surface of a substrate in the manufacture of a semicodcutor device for use in electronic applications.

For example, step (a) may be carried out in the presence of a cyanoethylation catalyst. This catalyst may be a base but is not limited to a base. Typically, catalysts used in cyanoethylation reactions comprise metal ions. However, the process can be adapted to produce an amidoxime for a semiconductor processing composition by, for example, using a cyanoethylation catalyst that is substantially free from metal ions. Suitable cyanoethylation catalysts include ammonium hydroxide and organic derivatives thereof (i.e. where one or more of the hydrogens on the ammonium cation is independently substituted with one or more 'R' groups as previously defined). For example, the catalyst may be selected from the group consisting of benzyltrimethylammonium hydroxide, dimethyldiethylammonium hydroxide, tetrabutylammonium hydroxide, tetraethylammonium hydroxide, tetramethylammonium hydroxide, tetramethylammonium hydroxide pentahydrate, tetrapropylammonium hydroxide, trimethylbenzylammonium hydroxide (Triton B).

To take a different aspect, hydroxylamine may be used to convert the cyanoethylation product into an amidoxime. In non-semiconductor applications, this hydroxylamine is typically produced *in situ* because hydroxylamine itself is considered explosive. This *in situ* manufacture typically comprises, for example, the deprotection of [NH₃(OH)]Cl with a base comprising a metal ion such as NaOBu. However, in order to produce an amidoxime that is substantially free from metal ions, preferably no reagents that comprise metal ions (apart from as unavoidable impurities) are used. Thus, either the hydroxylamine is provided in its deprotected form or it is generated *in situ* without using a reagent that comprises metal ions. Preferably, the hydroxylamine is provided as hydroxylamine free base.

This cyanoethylation reaction is particularly versatile, especially when applied to the synthesis of multidentate amidoxime compounds (i.e. molecules containing two or more amidoxime functional groups). In some embodiments, the nucleophile may have an oxygen or nitrogen centre. In other words, after the nucleophilic reaction, the nucleophile is connected to the acrylonitrile through oxygen or nitrogen. In other embodiments, the nucleophile is, for example but without limitation, carbon centered, phosphorus centered or sulphur centered.

For example, this cyanoethylation can be used to functionalize compounds having two or more NH groups. In one example, the reaction can be used to functionalize a molecule containing two or more primary amines. For example: 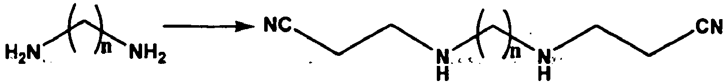 where n is 1 or more, for example 1 to 24.

Further functionalization of a primary amine is possible. For example, a tetradentate amidoxime, for example the functional equivalent of EDTA, may be conveniently formed: 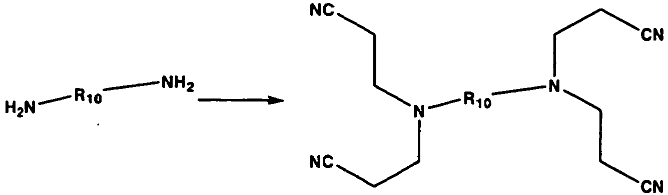 wherein R₁₀ is alkyl, heteroalkyl, aryl or heteroaryl. In an alternative conceived embodiment, R₁₀ is nothing: the starting material is hydrazine. An example of this reaction where R₁₀ is CH₂CH₂ is provided in the examples.

In a related embodiment, a molecule having two or more secondary amines can be functionalized: 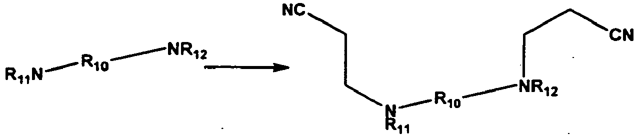 where R₁₀ is defined as above and R₁₁ and R₁₂ are independently selected alkyl, heteroalkyl, aryl or heteroaryl. Again, an embodiment where R₁₀ is nothing is contemplated.

For example, the secondary amines can be part of a cyclic system: 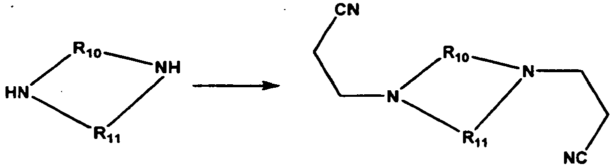 where R₁₀ and R₁₁ are defined above. For example, common solvent used in semiconductor processing can be functionalized with amidoxime functional groups. For example:

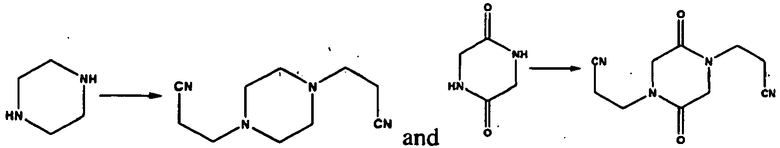

Similarly, an oxygen nucleophile may be used to provide nitrile precursors to amidoxime molecules. In one embodiment, the nucleophile is an alcohol: 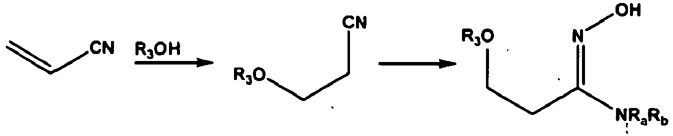 where R₃ is alkyl, heteroalkyl, aryl or heteroaryl.

For example, polyalcohol (polyol) compounds may be functionalized. Polyalcohols are molecules that contain more than one alcohol functional group. As an example, the following is a polyalcohol: 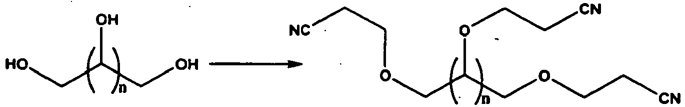 wherein n is 0 or more, for example 0 to 24. In one example, n is 0 (glycol). In another example, n is 6 (sorbitol).

In another example, the polyalcohol forms part of a polymer. For example, reaction may be carried out with a polymer comprising polyethylene oxide. For example, the polymer may contain just ethylene oxide units, or may comprise polyethylene oxide units as a copolymer (*i.e*. with one or more other monomer units). For example, the polymer may be a block copolymer comprising polyethylene oxide. For copolymers, especially block copolymers, the polymer may comprise a monomer unit not containing alcohol units. For example, the polymer may comprise blocks of polyethylene glycol (PEG). Copolymer (*e.g.* block copolymers) of polyethylene oxide and polyethylene glycol may be advantageous because the surfactant properties of the blocks of polyethylene glycol can be used and controlled.

Carbon nucleophiles can also be used. Many carbon nucleophiles are known in the art. For example, an enol group can act as a nucleophile. Harder carbon-based nucleophiles can be generated by deprotonation of a carbon. While many carbons bearing a proton can be deprotonated if a strong enough base is provided, it is often more convenient to be able to use a weak base to generate a carbon nucleophile, for example NaOEt or LDA. As a result, in one embodiment, a CH group having a pKₐ of 20 or less, for example, 15 or less, is deprotonated to form the carbon-based nucleophile

An example of a suitable carbon-based nucleophile is a molecule having the *beta*-diketone functionality (it being understood that the term *beta*-diketone also covers aldehydes, esters, amides and other C=O containing functional groups. Furthermore, one or both of the C=O groups may be replaced by NH or NOH). For example: 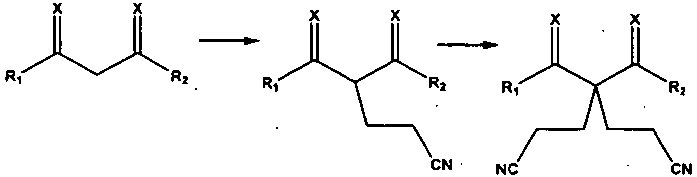 where R₁ and R₂ are independently selected alkyl groups, heteroalkyl groups, aryl groups, heteroaryl groups and heteroatoms.

Nitrile groups themselves act to lower the pKₐ of hydrogens in the *alpha* position. This in fact means that sometimes control of reaction conditions is preferably used to prevent a cyano compound, once formed by reaction of a nucleophile with acrylonitrile, from deprotonating at its *alpha* position and reacting with a second acrylonitrile group. For example, selection of base and reaction conditions (e.g. temperature) can be used to prevent this secondary reaction. However, this observation can be taken advantage of to functionalize molecules that already contain one or more nitrile functionalities. For example, the following reaction occurs in basic conditions:

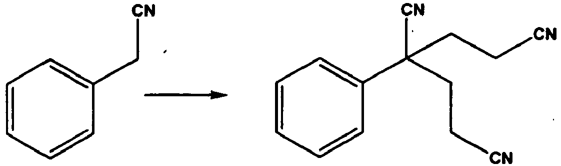

The cyanoethylation process usually requires a strong base as a catalyst. The use of a base catalyst comprising a metal is not preferred, for example the use of an alkali metal hydroxides such as, e.g., sodium oxide, lithium hydroxide, sodium hydroxide and potassium hydroxide. This is because these metals, in turn, can exist as impurities in the amidoxime compound solution. The existence of such metals in the amidoxime compound solution is not acceptable for use in electronic, and more specifically, semiconductor manufacturing processes and as stabilizer for hydroxylamine freebase and other radical sensitive reaction chemicals.

Preferably, alkali bases are metal ion-free organic ammonium hydroxide compound, such as tetramethylammonium hydroxide, trimethylbenzylammonium hydroxide and the like. In this context, the term *"organic"* means that one or more of the protons in the NH₄ cation has been replaced by an organic group such independently-selected alkyl, heteroalkyl, aryl and heteroaryl.

Preferably, the hydroxylamine used in the synthesis of the amidoxime is hydroxylamine freebase. Preferably, hydroxylamine generated in-situ by reacting hydroxylamine sulfate with sodium hydroxide is not used because this can result in unacceptable contamination of the amidoxime by metal ions.

In an embodiment, the amidoxime compound is a dendrimer having amidoxime surface groups. Dendrimers are individual molecules that have a core and dendrons attached to the core. Their definition is well-known in the art. The core has a branching point, onto which dendrons are attached. The branching point may be a single atom or it may be a group of atoms. Dendrimers are described as being a certain generation, referring to how many divisions occur in each dendron. For example, a second generation dendrimer comprises dendrons with their own branching point. In the present invention, the dendrimers are preferably first generation or greater. The outer generation of the dendrimer comprise the surface groups. Typically; each of the surface groups for each dendron are the same.

To take an illustrative example, the following molecule can be regarded as being a first generation dendrimer: 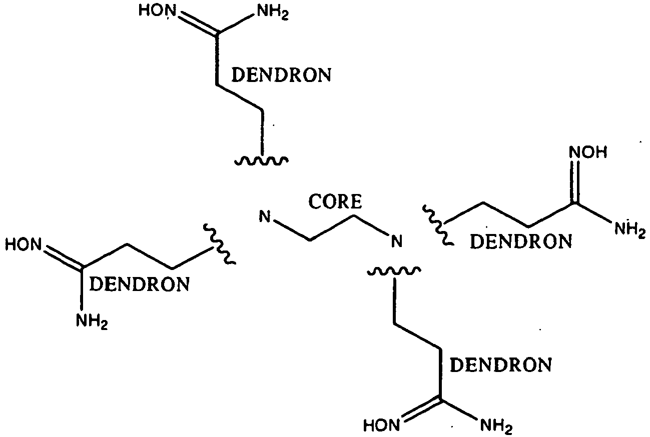 The core is shown as being a simple N-CH₂-CH₂-N moiety, with the dendron surface groups each comprising an amidoxime moiety. As described in *Supramolecular Chemistry* by Steed and Atwood, similar second generation dendrimers can easily be constructed:

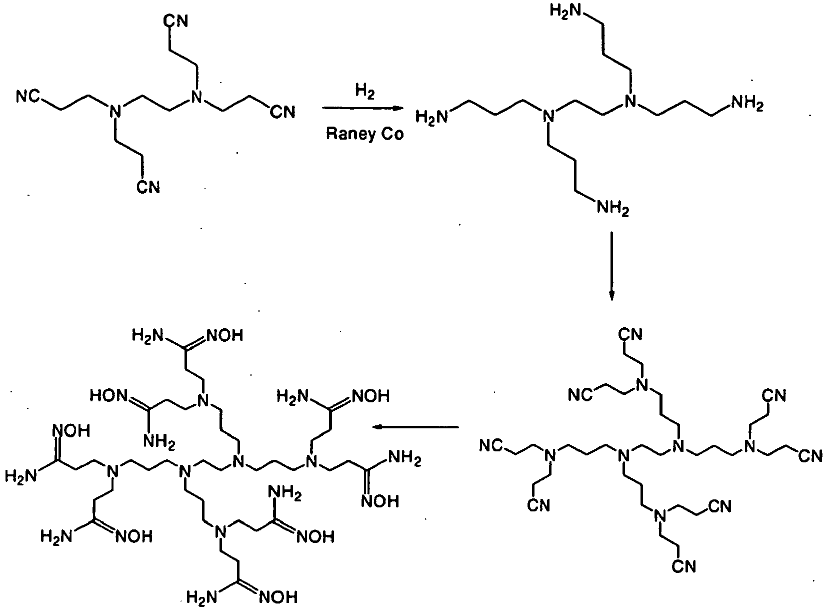

The inventors have found that dendrimers are a particularly versatile way to provide an amidoxime functional group. This is thought to be because dendrimers provide regular structure and facilitate the provision of multi-dentate amidoxime molecules. Their properties can also be conveniently tailored by varying the make up of the core and the dendrons.

Several examples already given in the specification can be considered to be examples of first generation dendrimers having amidoxime surface groups. These include:

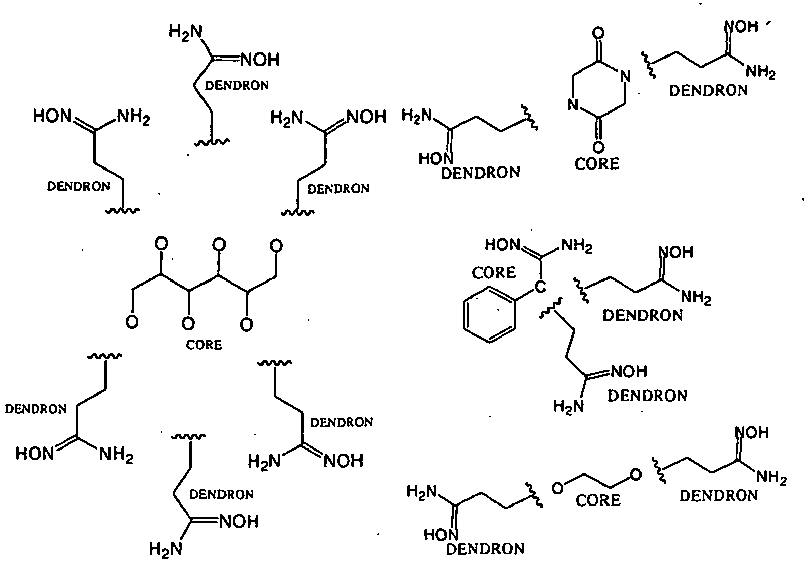

It is noted that in one of these examples the core is provided with an amidoxime functional group as well as the surface groups.

Accordingly, using a dendrimer comprising amidoxime functional groups is a versatile and efficient way of providing amidoxime compounds in a semiconductor processing composition. The use of acrylonitrile and acrylonitrile derivatives is especially versatile for the synthesis of dendrimers comprising amidoxime surface groups. The dendrimer amidoxime compounds produced according to the invention comprise two or more amidoxime groups, preferably two or more amidoxime surface groups.

Methods of synthesizing dendrimers are well known to the person skilled in the art. A divergent dendrimer synthesis allows for a dendrimer having regular surface groups to be constructed. Conversely, a convergent dendrimer synthesis allows dendrons with different surface groups to be incorporated into the dendrimer, thereby allowing further

Preferably, the dendrimer is a first generation dendrimer. With higher generation dendrimers, purification of the dendrimer becomes more complicated. With a first generation dendrimer, preferably the dendron surface groups are attached to the core through oxygen or nitrogen atoms.

One particular class of compounds that can be produced using the above advantageous cyanoethylation methodology is: 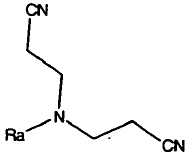 or substituted versions thereof (for example synthesized using a substituted acrylonitrile), wherein Rₐ is an aryl or heteroaryl group having an aromatic group in conjugation with the tertiary nitrogen. These compounds may be synthesized from the corresponding compounds having a free -NH₂ and reacting with an unsubstituted or substituted acrylonitrile.

In particular, Rₐ may comprise a substituted or unsubstituted six-membered heteroaryl group directly joined to the nitrogen (*i.e.* therefore having an aniline core or the corresponding heteroaryl version thereof). For example, Rₐ may be a substituted or unsubstituted phenyl, pyridyl, pyridyl *N*-oxide or furan group. This produces the following class of oximes: 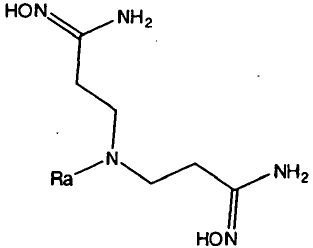 or substituted versions thereof (for example synthesized using a substituted acrylonitrile). For example, the following two compounds fall within the scope of the above class of compounds: 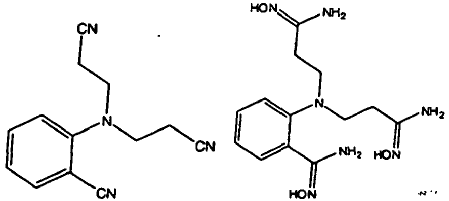 or substituted versions thereof (for example synthesized using a substituted acrylonitrile). This class of compounds is a particular versatile example of the more general class of multidentate amidoxime compounds that fall within the scope of the present invention.

### Other components of the semiconductor processing compositions

For the avoidance of doubt, the following description is applicable to any of the embodiments described above. A semiconductor processing composition according to the instant invention may contain one or more selected from the group consisting of water, solvent, acid, bases, activators, compounds having a redox potential and surfactants, sources of fluoride ions, chelating agents, and abrasives.

### A) Water

Within the scope of this invention, water may be introduced into the composition essentially only in chemically and/or physically bound form or as a constituent of the raw materials or compounds.

### B) Solvent (which is not water) - from about 1% to about 99% by weight.

The semiconductor processing composition of the present invention also includes 0% to about 99% by weight and more typically about 1% to about 80% by weight of a water miscible organic solvent, where the solvent(s) is/are preferably chosen from the group of water miscible organic solvents. In alternate embodiments, compositions of the invention include from about 1% to about 75%, from about 1% to about 65%, from about 1% to about 85%, from about 1% to about 90%, from about 1% to about 95%, from about 1% to about 97% by weight of the water miscible organic solvent.

Examples of water miscible organic solvents include, but are not limited to, dimethylacetamide (DMAC), N-methyl pyrrolidinone (NMP), N-Ethyl pyrrolidone (NEP), N-Hydroxyethyl Pyrrolidone (HEP), N-Cyclohexyl Pyrrolidone (CHP) dimethylsulfoxide (DMSO), Sulfolane, dimethylformamide (DMF), N-methylformamide (NMF), formamide, Monoethanol amine (MEA), Diglycolamine, dimethyl-2-piperidone (DMPD), morpholine, N-morpholine-N-Oxide (NMNO), tetrahydrofurfuryl alcohol, cyclohexanol, cyclohexanone, polyethylene glycols and polypropylene glycols, glycerol, glycerol carbonate, triacetin, ethylene glycol, propylene glycol, propylene carbonate, hexylene glycol, ethanol and n-propanol and/or isopropanol, diglycol, propyl or butyl diglycol, hexylene glycol, ethylene glycol methyl ether, ethylene glycol ethyl ether, ethylene glycol propyl ether, ethylene glycol mono-n-butyl ether, diethylene glycol methyl ether, diethylene glycol ethyl ether, propylene glycol methyl, ethyl or propyl ether, dipropylene glycol methyl or ethyl ether, methoxy, ethoxy or butoxy triglycol, I-butoxyethoxy-2-propanol, 3-methyl-3-methoxybutanol, propylene glycol t-butyl ether,and other amides, alcohols or pyrrolidones, ketones, sulfoxides; or multifunctional compounds, such as hydroxyamides or aminoalcohols, and mixtures of these solvents thereof. The preferred solvents, when employed, are dimethyl acetamide and dimethyl-2-piperidone, dimethylsufoxide and N-methylpyrrolidinone, diglycolamine, and monoethanolamine.

### C) Acids - From about 0.001 % to about 15% by weight

Possible acids are either inorganic acids or organic acids provided these are compatible with the other ingredients. Inorganic acids include hydrochloric acid, hydrofluoric acid, sulfuric acid, phosphoric acid, phosphorous acid, hypophosphorous acid, phosphonic acid, nitric acid, and the like. Organic acids include monomeric and/or polymeric organic acids from the groups of unbranched saturated or unsaturated monocarboxylic acids, of branched saturated or unsaturated monocarboxylic acids, of saturated and unsaturated dicarboxylic acids, of aromatic mono-, di- and tricarboxylic acids, of sugar acids, of hydroxy acids, of oxo acids, of amino acids and/or of polymeric carboxylic acids are preferred.

From the group of unbranched saturated or unsaturated monocarboxylic acids: methanoic acid (formic acid), ethanoic acid (acetic acid), propanoic acid (propionic acid), pentanoic acid (valeric acid), hexanoic acid (caproic acid), heptanoic acid (enanthic acid), octanoic acid (caprylic acid), nonanoic acid (pelargonic acid), decanoic acid (capric acid), undecanoic acid, dodecanoic acid (lauric acid), tridecanoic acid, tetradecanoic acid (myristic acid), pentadecanoic acid, hexadecanoic acid (palmitic acid), heptadecanoic acid (margaric acid), octadecanoic acid (stearic acid), eicosanoic acid (arachidic acid), docosanoic acid (behenic acid), tetracosanoic acid (lignoceric acid), hexacosanoic acid (cerotic acid), triacontanoic acid (melissic acid), 9c-hexadecenoic acid (palmitoleic acid), 6c-octadecenoic acid (petroselic acid), 6t-octadecenoic acid (petroselaidic acid), 9c-octadecenoic acid (oleic acid), 9t-octadecenoic acid (elaidic acid), 9c,12c-octadecadienoic acid (linoleic acid), 9t,12t-octadecadienoic acid (linolaidic acid) and 9c,12c,15c-octadecatrienoic acid (linolenic acid).

From the group of branched saturated or unsaturated monocarboxylic acids: 2-methylpentanoic acid, 2-ethylhexanoic acid, 2-propylheptanoic acid, 2-butyloctanoic acid, 2-pentylnonanoic acid, 2-hexyldecanoic acid, 2-heptylundecanoic acid, 2-octyldodecanoic acid, 2-nonyltridecanoic acid, 2-decyltetradecanoic acid, 2-undecylpentadecanoic acid, 2-dodecylhexadecanoic acid, 2-tridecylheptadecanoic acid, 2-tetradecyloctadecanoic acid, 2-pentadecylnonadecanoic acid, 2-hexadecyleicosanoic acid, 2-heptadecylheneicosanoic acid.

From the group of unbranched saturated or unsaturated di- or tricarboxylic acids: propanedioic acid (malonic acid), butanedioic acid (succinic acid), pentanedioic acid (glutaric acid), hexanedioic acid (adipic acid), heptanedioic acid (pimelic acid), octanedioic acid (suberic acid), nonanedioic acid (azelaic acid), decanedioic acid (sebacic acid), 2c-butenedioic acid (maleic acid), 2t-butenedioic acid (fumaric acid), 2-butynedicarboxylic acid (acetylenedicarboxylic acid).

From the group of aromatic mono-, di- and tricarboxylic acids: benzoic acid, 2-carboxybenzoic acid (phthalic acid), 3-carboxybenzoic acid (isophthalic acid), 4-carboxybenzoic acid (terephthalic acid), 3,4-dicarboxybenzoic acid (trimellitic acid), and 3,5-dicarboxybenzoic acid (trimesionic acid).

From the group of sugar acids: galactonic acid, mannonic acid, fructonic acid, arabinonic acid, xylonic acid, ribonic acid, 2-deoxyribonic acid, alginic acid.

From the group of hydroxy acids: hydroxyphenylacetic acid (mandelic acid), 2-hydroxypropionic acid (lactic acid), hydroxysuccinic acid (malic acid), 2,3-dihydroxybutanedioic acid (tartaric acid), 2-hydroxy-1,2,3-propanetricarboxylic acid (citric acid), ascorbic acid, 2-hydroxybenzoic acid (salicylic acid), an d 3,4,5-trihydroxybenzoic acid (gallic acid).

From the group of oxo acids: 2-oxopropionic acid (pyruvic acid) and 4-oxopentanoic acid (levulinic acid).

From the group of amino acids: alanine, valine, leucine, isoleucine, proline, tryptophan, phenylalanine, methionine, glycine, serine, tyrosine, threonine, cysteine, asparagine, glutamine, aspartic acid, glutamic acid, lysine, arginine, and histidine.

In one embodiment of the invention, the semiconductor processing composition contains from about 0.001% to about 15% by weight, alternatively from about 1% to about 10%, alternatively from about 0.1% to about 15%, alternatively from about 0.01% to about 12.5%, alternatively from about 0.001% to about 5% by weight of acid(s).

### D) Bases - from about 1% to about 45 % by weight

Possible bases are either inorganic bases or organic bases provided these are compatible with the other ingredients. Inorganic bases include sodium hydroxide, lithium hydroxide, potassium hydroxide, ammonium hydroxide and the like. Organic bases including organic amines, and quaternary alkylammonium hydroxide which may include, but are not limited to, tetramethylammonium hydroxide (TMAH), TMAH pentahydrate, benzyltetramethylammonium hydroxide (BTMAH), TBAH, choline, and Tris(2-hydroxyethyl)methylammonium hydroxide (TEMAH).

In one embodiment, the semiconductor processing composition contains from about 1% to about 45%, alternatively from about 1% to about 15%, alternatively from about 1% to about 20%, alternatively from about 1% to about 30%, alternatively from about 1% to about 35%, alternatively from about 1% to about 40% by weight of base(s).

### F) Activator - from about 0.001% to about 25% by weight

According to the present invention, the semiconductor processing compositions comprise one or more substances from the group of activators, in particular from the groups of polyacylated alkylenediamines, in particular tetraacetylethylenediamine (TAED), N-acylimides, in particular N-nonanoylsuccinimide (NOSI), acylated phenolsulfonates, in particular n-nonanoyl- or isononanoyloxybenzenesulfonate (n- or iso-NOBS) and n-methylmorpholiniumacetonitrile, methylsulfate (MMA), and "nitrile quaternary" compound in amounts of from 0.1 to 20% by weight, preferably from 0.5 to 15% by weight and in particular from 1 to 10% by weight, in each case based on the total composition to enhance the oxidation/reduction performance of the cleaning solutions. The "nitrile quats ", cationic nitrites has the formula,

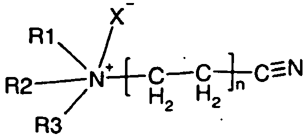

in which R₁ is -H, -CH₃, a C₂₋₂₄-alkyl or a C₂₋₂₄-alkenyl radical, a substituted methyl, substituted C₂₋₂₄-alkyl or substituted C₂₋₂₄-alkenyl radical, wherein the substituted radicals contain at least one substituent from the group -Cl, -Br, -OH, - NH₂, -CN, an alkyl-aryl or alkenyl-aryl radical with a C₁₋₂₄-alkyl group, a substituted alkyl-aryl or substituted alkenyl-aryl radical with a C₁₋₂₄-alkyl group, at least one further substituent on the aromatic ring; R₂ and R₃, independently of one another, are chosen from -CH₂-CN, -CH₃, -CH₂-CH₃, -CH₂-CH₂-CH₃, -CH(CH₃)-CH₃, - CH₂-OH, -CH₂-CH₂-OH, -CH(OH)CH₃, -CH₂-CH₂-CH₂-OH, -CH₂-CH(OH)-CH₃, -CH(OH)-CH₂-CH₃, and -(CH₂CH₂-O)ₙH, where n=1, 2, 3, 4, 5 or 6 and X is an anion.

A semiconductor processing composition according may optionally contain from about 0.001% to about 25% by weight, alternatively from about 1% to about 10%, alternatively from about 0.1% to about 15%, alternatively from about 0.01% to about 20%, alternatively from about 0.001% to about 5% by weight of an activator.

### G) Compounds having oxidation and reduction potential - From about 0.001% to about 25% by weight

These compounds include hydroxylamine and its salts, such as hydroxylamine chloride, hydroxylamine nitrate, hydroxylamine sulfate, hydroxylamine phosphate or its derivatives, such as N,N-diethylhydroxylamine, N-Phenylhydroxylamine, Hydrazine and its derivatives; hydrogen peroxide; persulfate salts of ammonium, potassium and sodium, permanganate salt of potassium, sodium; and other sources of peroxide are selected from the group consisting of: perborate monohydrate, perborate tetrahydrate, percarbonate, salts thereof, and combinations thereof. For environmental reasons, hydroxylamine phosphate is not preferred.

Other compounds which may be used as ingredients within the scope of the present invention are the diacyl peroxides, such as, for example, dibenzoyl peroxide. Further typical organic compounds which have oxidation/reduction potentials are the peroxy acids, particular examples being the alkyl peroxy acids and the aryl peroxy acids. Preferred representatives are (a) peroxybenzoic acid and its ring substituted derivatives, such as alkylperoxybenzoic acids, but also peroxy-a-naphthoic acid and magnesium monoperphthalate, (b) the aliphatic or substituted aliphatic peroxy acids, such as peroxylauric acid, peroxystearic acid, c-phthalimidoperoxycaproic acid [phthaloiminoperoxyhexanoic acid (PAP)], o-carboxybenzamidoperoxycaproic acid, N-nonenylamidoperadipic acid and N-nonenylamidopersuccinate, and (c) aliphatic and araliphatic peroxydicarboxylic acids, such as 1,2-diperoxycarboxylic acid, 1,9-diperoxyazelaic acid, diperoxysebacic acid, diperoxybrassylic acid, the diperoxyphthalic acids, 2-decyldiperoxybutane-1,4-dioic acid, N,N-terephthaloyldi(6-aminopercaproic acid) may be used.

The semiconductor processing composition according may optionally contain from about 0.001% to about 25% by weight, alternatively from about 1% to about 10%, alternatively from about 0.1% to about 15%, alternatively from about 0.01% to about 20%, alternatively from about 0.001% to about 5% by weight of compounds having oxidation and reduction potential.

### H) Other Chelating agents

Preferably, the semiconductor processing composition additionally comprises (by weight of the composition) from about 0.0% to about 15% by weight of one or more chelant. In one embodiment, the semiconductor composition comprises from about 0.001% to about 15%, alternatively from about 0.01% to about 10%, alternatively from about 0.1% to about 5% by weight of one or more chelant.

A further possible group of ingredients are the chelate complexing agents. Chelate complexing agents are substances which form cyclic compounds with metal ions, where a single ligand occupies more than one coordination site on a central atom, *i.e.* is at least "bidentate". In this case, stretched compounds are thus normally closed by complex formation via an ion to give rings. The number of bonded ligands depends on the coordination number of the central ion. Complexing groups (ligands) of customary complex forming polymers are iminodiacetic acid, hydroxyquinoline, thiourea, guanidine, dithiocarbamate, hydroxamic acid, amidoxime, aminophosphoric acid, (cycl.) polyamino, mercapto, 1,3-dicarbonyl and crown ether radicals, some of which have very specific activities toward ions of different metals.

For the purposes of the present invention, it is possible to use complexing agents of the prior art. These may belong to different chemical groups. Preferred chelating/complexing agents include the following, individually or in a mixture with one another:
1) polycarboxylic acids in which the sum of the carboxyl and optionally hydroxyl groups is at least 5, such as gluconic acid;
2) nitrogen-containing mono- or polycarboxylic acids, such as *e.g.* ethylenediaminetetraacetic acid (EDTA), N-hydroxyethylethylenediaminetriacetic acid, diethylenetriaminepentaacetic acid, hydroxy-ethyliminodiacetic acid, nitridodiacetic acid-3-propionic acid, isoserinediacetic acid, N,N-di(β-hydroxyethyl)glycine, N-(1,2-dicarboxy-2-hydroxyethyl)glycine, N-(1,2-dicarboxy-2-hydroxyethyl)-aspartic acid or nitrilotriacetic acid (NTA);
3) geminal diphosphonic acids, such as *e.g.* 1-hydroxyethane-1,1-diphosphonic acid (HEDP), higher homologs thereof having up to 8 carbon atoms, and hydroxy or amino group-containing derivatives thereof and 1-aminoethane-1,1-diphosphonic acid, higher homologs thereof having up to 8 carbon atoms, and hydroxy or amino group-containing derivatives thereof;
4) aminophosphonic acids, such as ethylenediamine-tetra(methylenephosphonic acid), diethylenetriaminepenta (methylenephosphonic acid) or nitrilotri(methylenephosphonic acid);
5) phosphonopolycarboxylic acids, such as 2-phosphonobutane-1,2,4-tricarboxylic acid; and
6) cyclodextrins.

### H) Surfactants - From about 10 ppm to about 5% by weight

The compositions according to the invention may thus also comprise anionic, cationic, and/or amphoteric surfactants as surfactant component. The compositions may comprise from about 10 ppm to about 5%, alternatively from about 10 ppm to about 100 ppm, alternatively from about 0.001% to about 5%, alternatively from about 0.01% to about 2.5%, alternatively from about 0.1% to about 1% by weight of one or more anionic, cationic, and/or amphoteric surfactants.

### I) Source of fluoride ions - From an amount about 0.001 % to 10% by weight

Sources of fluoride ions include, but are not limited to, ammonium bifluoride, ammonium fluoride, hydrofluoric acid, sodium hexafluorosilicate, fluorosilicic acid, and tetrafluoroboric acid.

The semiconductor processing composition may optionally contain from about 0.001% to about 10% by weight, alternatively from about 1% to about 10%, alternatively from about 0.1% to about 10%, alternatively from about 0.01% to about 1%, alternatively from about 0.001% to about 5% by weight of a source of fluoride ion.

### J) Abrasives

The composition of the present invention may also comprise abrasives for use in Chemical Mechanical Polishing. Abrasives are well known to the person skilled in the art. Exemplary abrasives include but are not limited to silica and alumina.

The components of the claimed compositions can be metered and mixed in situ just prior dispensing to the substrate surface for treatment. Furthermore, analytical devices can be installed to monitor the composition and chemical ingredients can be reconstituted to mixture to the specification to deliver the cleaning performance. Critical parameters that can be monitored include physical and chemical properties of the composition, such as pH, water concentration, oxidation/reduction potential and solvent components.

### Exemplary amidoxime compounds

While amidoxime compounds have been referred to previously as chelating agents, it will be understood by the person skilled in the art that they may perform several different functions. For example, they may be surfactants, corrosion inhibitors, radical inhibitors, or surface passivation agents. For example, if the amidoxime is in conjugation with an aromatic system, the amidoxime may have a low oxidation potential and therefore be suitable for use as a radical inhibitor and / or corrosion inhibitor and / or a surface passivation agent. The person skilled in the art will recognize that the 'gentle' chemistry that amidoxime compounds offer can be taken advantage of in many different capacities.

For the avoidance of doubt, the word *"may"* as used herein indicates the presence of an optional feature. In other words, the word *"may"* can be substituted with *"is preferably"* or *"is typically".*

Generally all known water-soluble multi-amidoxime compounds can be suitable for use in the composition and process of the present invention. Of particular interest are those amidoxime compounds useful in the semiconductor industry such as, for example, those selected from the examples that follow. These exemplary amidoxime compounds also include a reaction pathway for their synthesis.

In one embodiment of the invention, the one or more amidoxime is selected from the group consisting of 1,2,3,4,5,6-hexakis-O-[3-(hydroxyamino)-3-iminopropyl Hexitol, 3,3',3",3"'-(ethane-1,2-diylbis(azanetriyl))tetrakis(N'-hydroxypropanimidamide), 3,3'-(ethane-1,2-diylbis(oxy))bis(N'-hydroxypropanimidamide), 3,3'-(piperazine-1,4-diyl)bis(N'-hydroxypropanimidamide), 3,3',3"-nitrilotris(N'-hydroxypropanimidamide), 3,3'-(2,2-bis((3-(hydroxyamino)-3-iminopropoxy)methyl)propane-1,3-diyl)bis(oxy)bis(N-hydroxypropanimidamide), 3,3'-(2,2'-(methylazanediyl)bis(ethane-2,1-diyl)bis(oxy))bis(N'-hydroxypropanimidamide), N,N-bis(3-amino-3-(hydroxyimino)propyl)acetamide, 3,3'-(2-(N'-hydroxycarbamimidoyl)phenylazanediyl)bis(N'-hydroxypropanimidamide), 3,3'-(2,2'-(3-amino-3-(hydroxyimino)propylazanediyl)bis(ethane-2,1-diyl))bis(oxy)bis(N'-hydroxypropanimidamide), 3,3'-azanediylbis(N'-hydroxypropanimidamide), N'¹,N^{,6}-dihydroxyadipimidamide, N'¹,N'¹⁰-dihydroxydecanebis(imidamide), and mixtures thereof.

Preferred amidoxime compounds include, but are not limited to, those recited in Tables 1 and 2 below.

| **Table 1: Exemplary Preferred amidoxime compounds** | | |
|---|---|---|
| **Nitrile (N)** | | **Amidoxime (AO)** |
| 8 | 3,3' iminodipropionitrile | 3,3'-azanediylbis(N'-hydroxypropanimidamide) |
| 11 | ethyl 2-cyanoacetate | 3-amino-N-hydroxy-3-(hydroxyimino)propanamide |
| 15 | adiponitrile | N'1,N'6-dihydroxyadipimidamide |
| 16 | sebaconitrile | N'1,N'10-dihydroxydecanebis(imidamide) |
| 25 | 3,3' iminodiacetonitrile | 2,2'-azanediylbis(N'-hydroxyacetimidamide) |

| **Table 2: Exemplary Preferred amidoxime compounds** | | | |
|---|---|---|---|
| **ID** | **Nucleophilic compounds** | **Cyanoethylated Compounds (CE)** | **Amidoxime from cyanoethylated compounds (AO)** |
| 01 | Sorbitol | 1,2,3,4,5,6-hexakis-O-(2-. kyanoetyl)hexitol | 1,2,3,4,5,6-hexakis-O-[3-(hydroxyamino)-3-iminopropyl hexitol |
| 07 | ethylenediamine | 3,3',3",3"'-(ethane-1,2-diylbis(azanetriyl))tetrapropanenitri.le . | 3,3',3",3"'-(ethane-1,2-diylbis(azanetriyl))tetrakis(N'-hydroxypropanimidamide) |
| 28 | ethylene glycol | 3,3'-(ethane-1,2-diylbis(oxy))dipropanenitrile | 3,3'-(ethane-1,2-diylbis(oxy))bis(N'-hydroxypropanimidamide) |
| 35 | piperazine | 3,3'-(piperazine-1,4-diyl)dipropanenitrile | 3,3'-(piperazine-1,4-diyl)bis(N'-hydroxypropanimidamide) |
| 39 | diethyl malonate | diethyl 2,2-bis(2-cyanoethyl) malonate | 2,2-bis(3-amino-3-(hydroxyimino)propyl)malonic acid |
| 41 | ammonia | 3,3',3"-nitrilotri propanenitrile | 3,3',3"-nitrilotris(N'-hydroxypropanimidamide) |
| 42 | diethyl malonate | 2,2-bis(2-cyanoethyl) malonic acid | 2,2-bis(3-amino-3-(hydroxyimino)propyl)malonic acid |
| 44 | glycine (dicyanothylated) | 2-(bis(2-cyanoethyl)amino) acetic acid | 2-(bis(3-amino-3-(hydroxyimino)propyl)amino)acetic acid |
| 45 | malononitrile | propane-1,1,3-tricarbonitrile | N1,N'1,N'3-trihydroxypropane-1,1,3-tris(carboximidamide) |
| 46 | cyanoacetamide | 2,4-dicyano-2-(2-cyanoethyl)butanamide | 5-amino-2-(3-amino-3-(hydroxyimino)propyl)-2-(N'-hydroxycarbamimidoyl)-5-(hydroxyimno)pentanamide |
| 47 | Pentaerythritol | 3,3'-(2,2-bis((2-cyanoethoxy) methyl) propane-1,3-diyl)bis(oxy) dipropanenitrile | 3,3'-(2,2-bis((3-(hydroxyamino)-3-iminopropoxy)methyl)propane-1,3-diyl)bis(oxy)bis(N-hydroxypropanimidamide) |
| 48 | N-methyl diethanol amine | 3,3'-(2,2'-(methylazanediyl)bis(ethane-2,1-diyl) bis(oxy))dipropanenitrile | 3,3'-(2,2'-(methylazanediyl)bis(ethane-2,1-diyl)bis(oxy))bis(N'-hydroxypropanimidamide) |
| 49 | glycine anhydride | 3,3'-(2,5-dioxopiperazine-1,4-diyl)dipropanenitrile | 3,3'-(2,5-dioxopiperazine-1,4-diyl)bis(N'-hydroxypropanimidamide) |
| 50 | acetamide | N,N-bis(2-cyanoethyl)acetamide | N,N-bis(3-amino-3-(hydroxyimino)propyl)acetamide |
| 51 | anthranilonitrile | 3,3'-(2-cyanophenylazanediyl) dipropanenitrile | 3,3'-(2-(N'-hydroxycarbamimidoyl)phenylazanediyl)bis(N'-hydroxypropanimidamide) |
| 52 | diethanolamine | 3,3'-(2,2'-(2-cyanoethylazanediyl)bis(ethane-2,1-diyl)bis(oxy))dipropane nitrile | 3,3'-(2,2'-(3-amino-3-(hydroxyimino)propylazanediyl)bis(ethane-2,1-diyl))bis(oxy)bis(N'-hydroxypropanimidamide) |

### EXAMPLES

Nomenclatures are translated from chemical structures to their corresponding chemical names using ChemBioDraw Ultra from CambridgeSoft, MA. The following abbreviations were in the examples.

| | |
|---|---|
| Boiling point | Bp |
| Catalytic | Cat |
| Decomposed | Dec |
| Equivalent | eq |
| Ethanol | EtOH |
| Ether | Et₂O |
| Ethyl Acetate | EtOAc |
| Ethylenediamine tetracarboxylic acid | DETA |
| Gram | g |
| Hydrochloride acid | HCl |
| Isopropyl Alcohol | iPrOH |
| Melting point | Mp |
| Methanol | MeOH |
| Methylene chloride | CH₂Cl₂ |
| Millimole or mole | Mmol or mol |
| Room temperature | Rt, RT |
| Tetramethylammonium hydroxide (25% in water) | TMAH |
| Trimethylbenzylammonium hydroxide (40% in MeOH) | Triton B |

### Synthesis of exemplary amidoxime compounds

### Example 1: Reactions to produce nitrile precursors to amidoxime compounds

The following reactions are exemplary reactions that produce precursors of amidoxime compounds.

### C) Cyanoethylation of piperazinexine

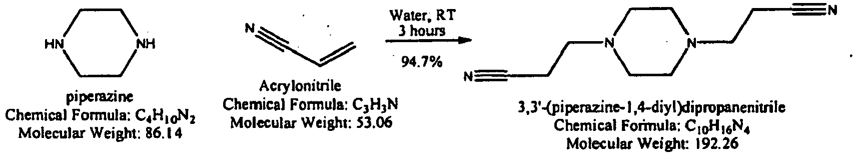

A solution of piperazine (1 g, 11.6 mmol) and acrylonitrile (1.6 g, 30.16 mmol, 2.6 eq) in water (10 cm³) were stirred at room temperature for 5 hours, after which the mixture was extracted with dichloromethane (2 × 50 cm³). The organic extracts were evaporated under reduced pressure to give the pure doubly cyanoethylated compound 3,3'-(piperazine-1,4-diyl)dipropanenitrile (2.14 g, 94.7%) as a white solid, mp 66-67 °C.

### H) Cyanoethylation of ethylenediamine

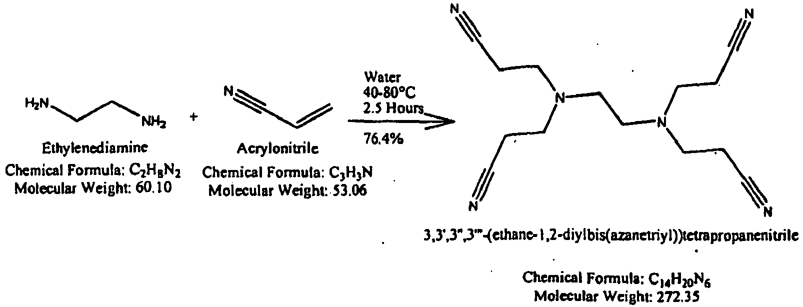

Acrylonitrile (110 g, 137 cm³, 2.08 mol) was added to a vigorously stirred mixture of ethylenediamine (25 g, 27.8 cm³, 0.416 mol) and water (294 cm³) at 40 °C over 30 min. During the addition, it was necessary to cool the mixture with a 25 °C water bath to maintain temperature at 40 °C. The mixture was then stirred for additional 2 hours at 40 °C and 2 hours at 80 °C. Excess acrylonitrile and half of the water were evaporated off and the residue, on cooling to room temperature, gave a white solid which was recrystallised from MeOH-water (9:1) to give pure product 3,3',3",3"'-(ethane-1,2-diylbis(azanetriyl))tetrapropanenitrile (86.6 g, 76.4%) as white crystals, mp 63-65 °C.

### I) Cyanoethylation of ethylene glycol

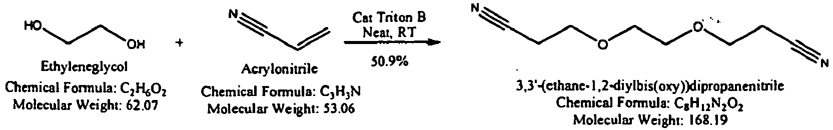

Small scale: Ethylene glycol (1 g, 16.1 mmol) was mixed with Triton B (40% in MeOH, 0.22 g, 0.53 mmol) and cooled in an ice-bath while acrylonitrile (1.71 g, 32.2 mmol) was added. The mixture was stirred at room temperature for 60 hours after which it was neutralized with 0.1 M HCl (0.6 cm³) and extracted with CH₂Cl₂ (80 cm³). The extracts were concentrated under reduced pressure and the residue was Kugelrohr-distilled to give 3,3'-(ethane-1,2-diylbis(oxy))dipropanenitrile (1.08 g, 39.9%) as a light coloured oil, bp 150-170 °C/20 Torr.

Large scale: Ethylene glycol (32.9 g, 0.53 mol) was mixed with Triton B (40% in MeOH, 2.22 g, 5.3 mmol) and cooled in an ice-bath while acrylonitrile (76.2 g, 1.44 mol) was added. The mixture was allowed to warm slowly to room temperature and stirred for 60 hours after which it was neutralized with 0.1 M HCl (50 cm³) and extracted with CH₂Cl₂ (300 cm³). The extracts were passed through a silica plug three times to reduce the brown colouring to give 86 g (quantitative yield) of the product as an amber coloured oil, pure by ¹H-NMR, containing 10 g of water (total weight 96 g, amount of water calculated by ¹H NMR integral sizes).

### J) Cyanoethylation of diethyl malonate

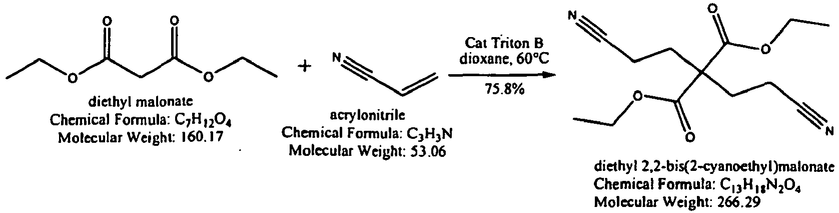

To a solution of diethyl malonate (1 g, 6.2 mmol) and Triton B (40% in MeOH, 0.13 g, 0.31 mmol) in dioxane (1.2 cm³) was added dropwise acrylonitrile (0.658 g, 12.4 mmol) and the mixture was stirred at 60 °C overnight. The mixture was then cooled to room temperature and neutralized with 0.1 M HCl (3 cm³) and poured to ice-water (10 cm³). Crystals precipitated during 30 min. These were collected by filtration and recrystallised from EtOH (cooling in freezer before filtering off) to give diethyl 2,2-bis(2-cyanoethyl)malonate (1.25 g, 75.8%) as a white solid, mp 62.2-63.5 °C.

### K) Hydrolysis of diethyl 2,2-bis(2-cyanoethyl)malonate

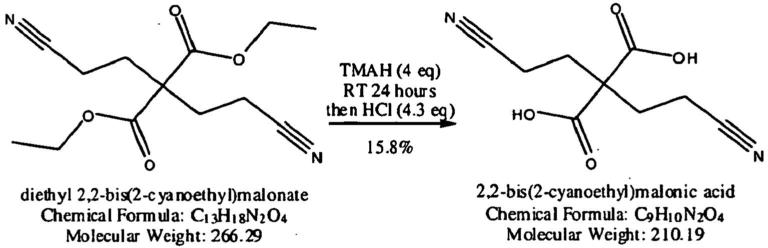

Diethyl 2,2-bis(2-cyanoethyl)malonate (2 g, 7.51 mmol) was added to TMAH (25% in water, 10.95 g, 30.04 mmol) at room temperature. The mixture was stirred for 24 hours, and was then cooled to 0 °C. A mixture of 12M HCl (2.69 cm³, 32.1 mmol) and ice (3 g) was added and the mixture was extracted with CH₂Cl₂ (5×50 cm³). The extracts were evaporated under vacuum to give 2,2-bis(2-cyanoethyl)malonic acid (0.25 g, 15.8%) as a colourless very viscous oil (lit decomposed. 158 °C).

### L) Dicyanoethylation of glycine to give 2-(bis(2-cyanoethyl)amino)acetic acid

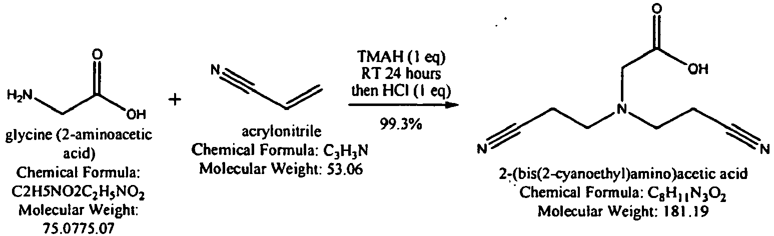

Glycine (5 g, 67 mmol) was suspended in water (10 cm³) and TMAH (25% in water, 24.3 g, 67 mmol) was added slowly, keeping the temperature at <30 °C with an ice-bath. The mixture was then cooled to 10 °C and acrylonitrile (7.78 g, 146 mmol) was added. The mixture was stirred overnight, and allowed to warm to room temperature slowly. It was then heated at 50 °C for 2 hours, using a reflux condenser. After cooling with ice, the mixture was neutralized with HCl (6M, 11.1 cm³) and concentrated to viscous oil. This was dissolved in acetone (100 cm³) and filtered to remove NMe₄Cl. The filtrate was concentrated under reduced pressure to give an oil that was treated once more with acetone (100 cm³) and filtered to remove more NMe₄Cl. Concentration of the filtrate gave 2-(bis(2-cyanoethyl)amino)acetic acid (11.99 g, 99.3%) as a colourless, viscous oil that crystallised over 1 week at room temperature to give a solid product, mp 73 °C (lit mp 77.8-78.8 °C. Duplicate ¹³C signals indicate a partly zwitterionic form in CDCl₃ solution.

When NaOH is used in the literature procedure, the NaCl formed is easier to remove and only one acetone treatment is necessary.

### M) Dicyanoethylation of N-methyldiethanolamine to give 3,3'-(2,2'(methylazanediyl)bis(ethane-2,1-diyl)bis(oxy))dipropanenitrile

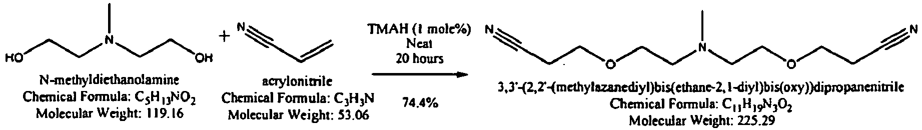

To a cooled, stirred mixture of N-methyldiethanolamine (2 g, 17 mmol) and acrylonitrile (2.33 g, 42 mmol) was added TMAH (25% in water, 0.25 cm³, 0.254 g, 7 mmol). The mixture was then stirred overnight and allowed to warm to room temperature slowly. It was then filtered through silica using a mixture of Et₂O and CH₂Cl₂ (1:1, 250 cm³) and the filtrated was evaporated under reduced pressure to give 3,3'-(2,2'-(methylazanediyl)bis(ethane-2,1-diyl)bis(oxy))dipropanenitrile (2.85 g, 74.4%) as a colourless oil.

### N) Dicyanoethylation of glycine anhydride

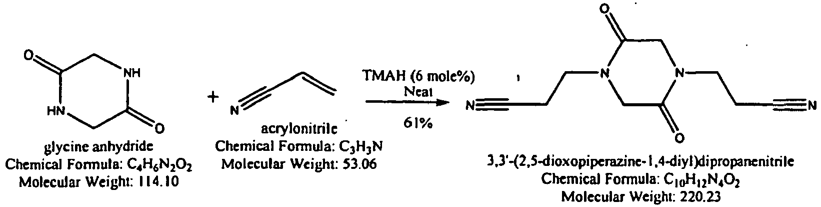

Glycine anhydride (2 g, 17.5 mmol) was mixed with acrylonitrile (2.015 g, 38 mmol) at 0 °C and TMAH (25% in water, 0.1 cm³, 0.1 g, 2.7 mmol) was added. The mixture was then stirred overnight, allowing it to warm to room temperature slowly. The solid formed was recrystallised from EtOH to give 3,3'-(2,5-dioxopiperazine-1,4-diyl)dipropanenitrile (2.35 g, 61%) as a white solid, mp 171-173 °C (lit mp 166 °C).

### O) N,N-Dicyanoethylation of acetamide

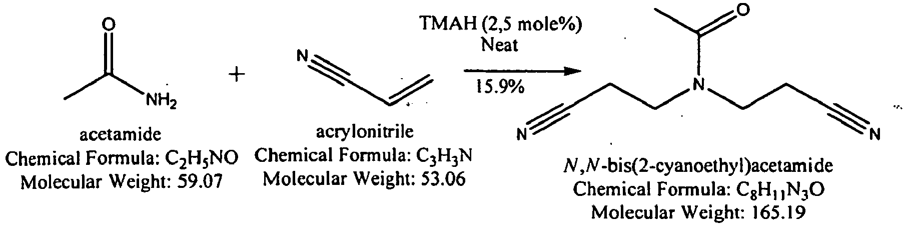

Acetamide (2 g, 33.9 mmol) was mixed with acrylonitrile-(2.26 g, 42.7 mmol) at 0 °C and TMAH (25% in water, 0.06 cm³, 0.06 g, 1.7 mmol) was added. The mixture was then stirred overnight, allowing it to warm to room temperature slowly. The mixture was filtered through a pad of silica with the aid of Et₂O/CH₂Cl₂ (200 cm³) and the filtrate was concentrated under reduced pressure. The product was heated with spinning in a Kugelrohr at 150 °C/2 mmHg to remove side products and to give N,N-bis(2-cyanoethyl)acetamide (0.89 g, 15.9%) as a viscous oil.

The N-substituent in the amides is non-equivalent due to amide rotation.

### P) Tricyanoethylation of ammonia

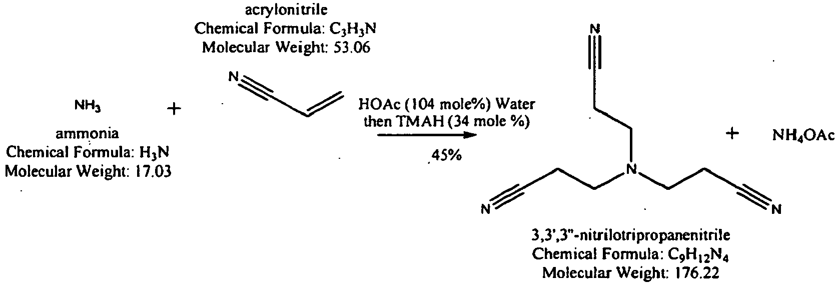

Ammonia (aq 35%, 4.29, 88 mmol) was added dropwise to ice-cooled AcOH (5.5 g, 91.6 mmol) in water (9.75 cm³), followed by acrylonitrile (4.65 g, 87.6 mol). The mixture was stirred under reflux for 3 days, after which it was cooled with ice and aqueous TMAH (25% in water, 10.94 g, 30 mmol) was added. The mixture was kept cooled with ice for 1 hour. The crystals formed was collected by filtration and washed with water. The product was dried in high vacuum to give 3,3',3"-nitrilotripropanenitrile (2.36 g, 45.8%) as a white solid, mp 59-61 °C (lit mp 59 °C).

When NaOH was used to neutralise the reaction (literature procedure), the yield was higher, 54.4%.

### Q) Dicyanoethylation of cyanoacetamide

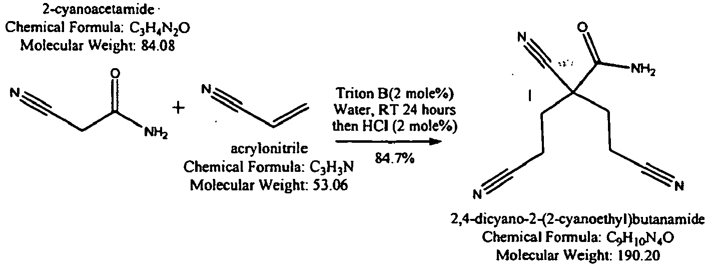

To a stirred mixture of cyanoacetamide (2.52 g, 29.7 mmol) and Triton B (40% in MeOH, 0.3 g, 0.7 mmol) in water (5 cm³) was added acrylonitrile (3.18 g, 59.9 mmol)over 30 minutes with cooling. The mixture was then stirred at room temperature for 30 min and then allowed to stand for 1 hour. EtOH (20g) and 1M HCl (0.7 cm³) were added and the mixture was heated until all solid had dissolved. Cooling to room temperature gave crystals that were collected by filtration and recrystallised from EtOH to give 2,4-dicyano-2-(2-cyanoethyl)butanamide (4.8 g, 84.7%) as a pale yellow solid, mp 118-120 °C (lit mp 118 °C),

### R) N,N-Dicyanoethylation of anthranilonitrile

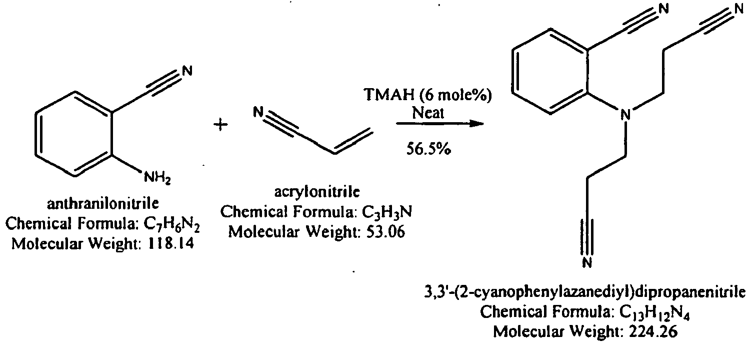

Anthranilonitrile (2 g, 16.9 mmol) was mixed with acrylonitrile (2.015 g, 38 mmol) at 0 °C and TMAH (25% in water, 0.1 cm³, 0.1 g, 2.7 mmol) was added. The mixture was then stirred overnight, allowing it to warm to room temperature slowly. The product was dissolved in CH₂Cl₂ and filtered through silica using a mixture of Et₂O and CH₂Cl₂ (1:1, 250 cm³). The filtrate was evaporated to dryness and the solid product was recrystallised from EtOH (5 cm³) to give 3,3'-(2-cyanophenylazanediyl)dipropanenitrile (2.14 g, 56.5%) as an off-white solid, mp 79-82 °C.

### S) Dicyanoethylation of malononitrile

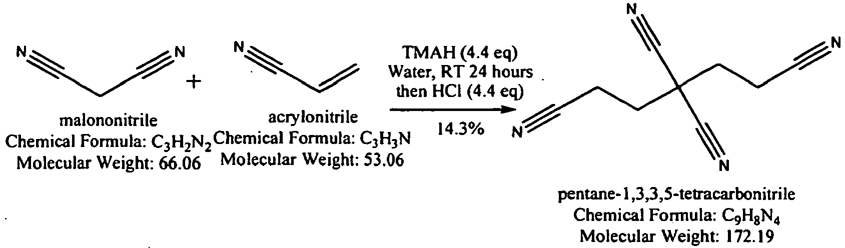

Malononitrile (5 g, 75.7 mmol) was dissolved in dioxane (10 cm³), followed by trimethylbenzylammonium hydroxide (Triton B, 40% in MeOH, 1.38 g, 3.3 mmol). The mixture was cooled while acrylonitrile (8.3 g, 156 mmol) was added. The mixture was stirred overnight, allowing it to warm to room temperature slowly. It was then neutralized with HCl (1 M, 3.3 cm³) and poured into ice-water. The mixture was extracted with CH₂Cl₂ (200 cm³) and the extracts were evaporated under reduced pressure: The product was purified by column chromatography (silica, 1:1 EtOAc-petroleum) followed by recrystallisation to give 1,3,3,5-tetracarbonitrile (1.86 g, 14.3%), mp 90-92°C (lit mp 92 °C).

### T) Tetracyanoethylation of pentaerythritol

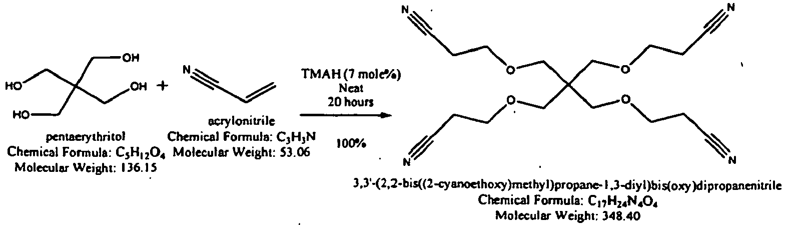

Pentaerythritol (2 g, 14.7 mmol) was mixed with acrylonitrile (5 cm³, 4.03 g, 76 mmol) and the mixture was cooled in an ice-bath while tetramethylammonium hydroxide (=TMAH, 25% in water, 0.25 cm³, 0.254 g, 7 mmol) was added. The mixture was then stirred at room temperature for 20 hours. After the reaction time the mixture was filtered through silica using a mixture of Et₂O and CH₂Cl₂ (1:1, 250 cm³) and the filtrated was evaporated under reduced pressure to give 3,3'-(2,2-bis((2-cyanoethoxy)methyl)propane-1,3-diyl)bis(oxy)dipropanenitrile (5.12 g, 100%) as a colourless oil.

### V) Hexacyanoethylation of sorbitol

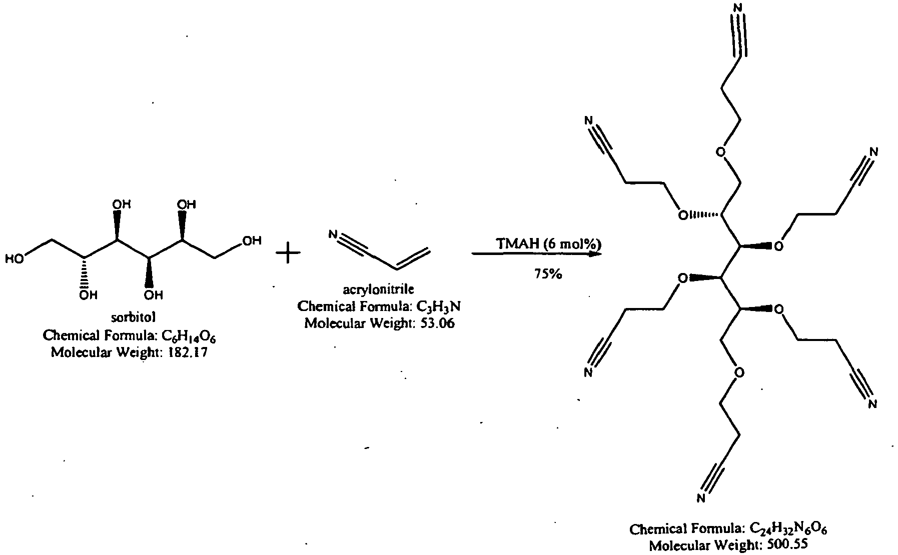

Sorbitol (2 g, 11 mmol) was mixed with acrylonitrile (7 cm³, 5.64 g, 106 mmol) and the mixture was cooled in an ice-bath while tetramethylammonium hydroxide (=TMAH, 25% in water, 0.25 cm³, 0.254 g, 7 mmol) was added. The mixture was then stirred at room temperature for 48 hours, adding another 0.25 cm³ of TMAH after 24 hours. After the reaction time, the mixture was filtered through silica using a mixture of Et₂O and CH₂Cl₂ (1:1, 250 cm³) and the filtrate was evaporated under reduced pressure to give a fully cyanoethylated product (4.12 g, 75%) as a colourless oil.

### W) Tricyanoethylation of diethanolamine to give 3,3'-(2,2'-(2-cyanoethylazanediyl)bis(ethane-2,1-diyl)bis(oxy))dipropanenitrile

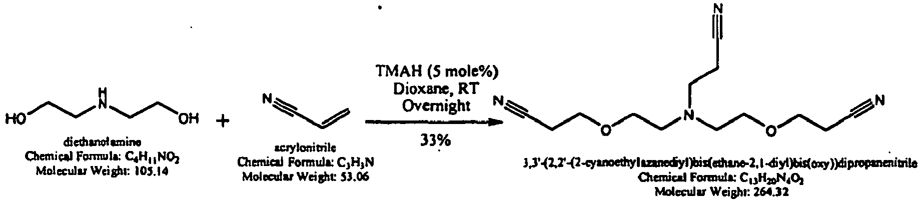

To an ice-cooled stirred solution of diethanolamine (2 g, 19 mmol) and TMAH (25% in water, 0.34 cm³, 0.35 g, 9.5 mmol) in dioxane (5 cm³) was added acrylonitrile (3.53 g, 66.1 mmol) dropwise. The mixture was then stirred overnight, and allowed to warm to room temperature. More acrylonitrile (1.51 g, 28 mmol) and TMAH (0.25 cm³, 7 mmol) was added and stirring was continued for additional 24 h. The crude mixture was filtered through a pad of silica (Et₂O/CH₂Cl₂ as eluent) and evaporated to remove dioxane. The residue was purified by column chromatography (silica, Et₂O to remove impurities followed by EtOAc to elute product) to give 3,3'-(2,2'-(2-cyanoethylazanediyl)bis(ethane-2,1-diyl)bis(oxy))dipropanenitrile (1.67 g, 33%) as an oil.

### Example 2: Reactions to produce amidoxime compounds

The following examples are reactions that can be used to produce amidoxime compounds according to one embodiment of the invention.

### D) Reaction of ethyl 2-cyanoacetate

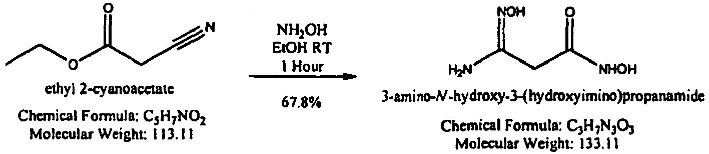

Ethyl cyanoacetate (1 g, 8.84 mmol) and hydroxylamine (50% in water, 1.19 cm3, 1.29 g, 19.4 mmol, 2.2 eq) in EtOH (1 cm³) were allowed to stand at room temperature for 1 hour with occasional swirling. The crystals formed were collected by filtration and dried in high vacuum line to give a colourless solid, 3-amino-N-hydroxy-3-(hydroxyimino)propanamide , mp 158 °C (decomposed) (lit mp 150 °C).

### G) Reaction of adiponitrile

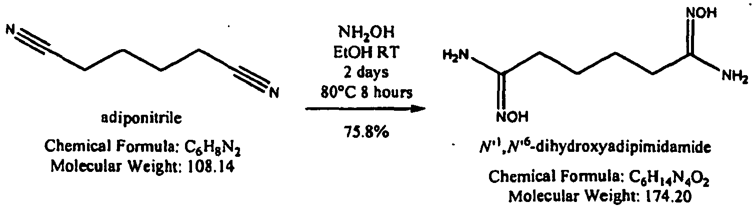

Adiponitrile (1 g, 9 mmol) and hydroxylamine (50% in water, 1.24 cm3, 1.34 g, 20 mmol, 2.2 eq) in EtOH (10 cm3) were stirred at room temperature for 2 days and then at 80 °C for 8 hours. The mixture was allowed to cool and the precipitated crystals were collected by filtration and dried in high vacuum line to give the product N'1,N'6-dihydroxyadipimidamide (1.19 g, 75.8%) as a white solid, mp 160.5 (decomposed) (lit decomposed 168-170 °C.

### H) Reaction of sebaconitrile

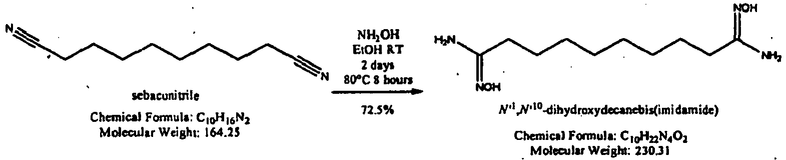

Sebaconitrile (1 g, 6 mmol) and hydroxylamine (50% in water, 0.85 cm³, 0.88 g, 13.4 mmol, 2.2 eq) in EtOH (12 cm³) were stirred at room temperature for 2 days and then at 80°C for 8 hours. The mixture was allowed to cool and the precipitated crystals were collected by filtration and dried in high vacuum line to give the product N'1,N'10-dihydroxydecanebis(imidamide) (1 g, 72.5%); mp 182°C.

### L) Reaction of iminodiacetonitrile

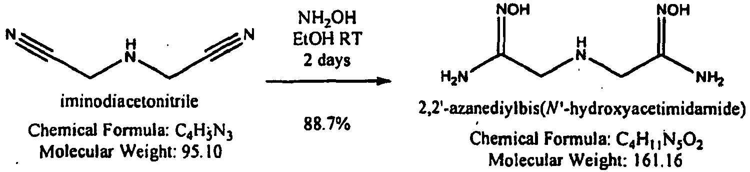

Commercial iminodiacetonitrile (Alfa-Aesar) was purified by dispersing the compound in water and extracting with dichloromethane, then evaporating the organic solvent from the extracts to give a white solid. Purified iminodiacetonitrile (0.82 g) and hydroxylamine (50% in water, 2.12 ml, 2.28 g, 34.5 mmol, 4 eq) in MeOH (6.9 ml) and water (6.8 ml) were stirred at room temperature for 48 hours. Evaporation of volatiles under reduced pressure gave a colorless liquid which was triturated with EtOH (40 °C) to give 2,2'-azanediylbis(N'-hydroxyacetimidamide) (1.23 g, 88.7%) as a white solid, mp 135-136 °C, (lit mp 138 °C).

### O) Reaction of 3,3',3"-nitrilotripropanenitrile with hydroxylamine to give 3,3',3"-nitrilotris(N'-hydroxypropanimidamide)

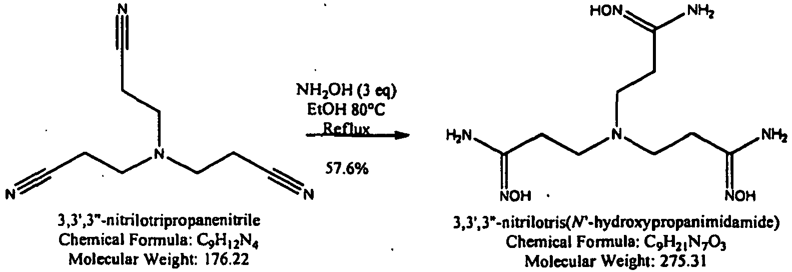

A solution of 3,3',3"-nitrilotripropanenitrile (2 g, 11.35 mmol) and hydroxylamine (50% in water, 2.25 g, 34 mmol) in EtOH (25 cm³) was stirred at 80 °C overnight, then at room temperature for 24 hours. The white precipitate was collected by filtration and dried in high vacuum to give 3,3',3"-nitrilotris(N'-hydroxypropanimidamide) (1.80 g, 57.6%) as a white crystalline solid, mp 195-197 °C (decomposed)

### R) Reaction of 3,3'-(2,2'-(2-cyanoethylazanediyl)bis(ethane-2,1-diyl)bis(oxy))dipropanenitrile with hydroxylamine to give 3,3'-(2,2'-(3-amino-3-(hydroxyimino)propylazanediyl)bis(ethane-2,1-diyl))bis(oxy)bis(N'-hydroxypropanimidamide)

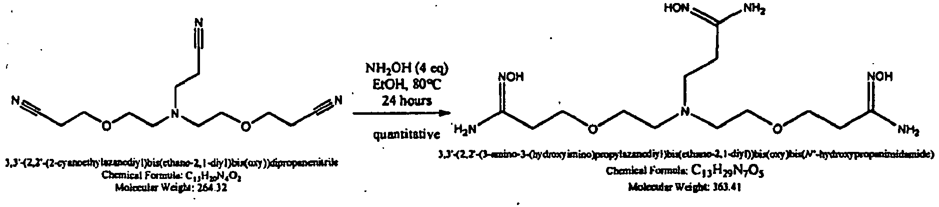

Treatment of 3,3'-(2,2'-(2-cyanoethylazanediyl)bis(ethane-2,1-diyl)bis(oxy))dipropanenitrile (0.8 g, 3 mmol) with NH₂OH (0.74 cm³, 12.1 mmol) in EtOH (8 cm³) gave 3,3'-(2,2'-(3-amino-3-(hydroxyimino)propylazanediyl)bis(ethane-2,1-diyl))bis(oxy)bis(N'-hydroxypropanimidamide) (1.09 g, 100%) as an oil.

### S) Reaction of iminodipropionitrile

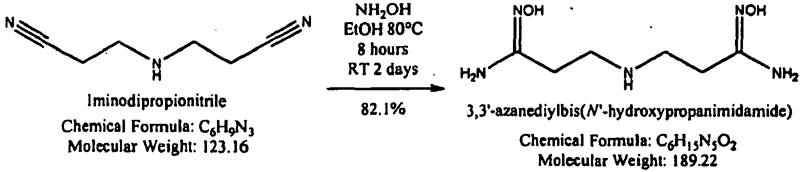

Iminodipropionitrile (1 g, 8 mmol) and hydroxylamine (50% in water, 1 cm³, 1.07 g, 16 mmol, 2 eq) in EtOH (8 cm³) were stirred at room temperature for 2 days and then at 80 °C for 8 hours. The mixture was allowed to cool and the precipitated crystals were collected by filtration and dried in high vacuum line to give the product 3,3'-azanediylbis(N'-hydroxypropanimidamide) (1.24 g, 82.1%) as a white solid, mp 180 °C (lit 160 °C).

### T) Reaction of 3,3',3",3"'-(ethane-1,2-diylbis(azanetriyl))tetrapropanenitrile to give 3,3',3",3"'-(ethane-1,2-diylbis(azanetriyl))tetrakis(N'-hydroxypropanimidamide) to produce EDTA analogue

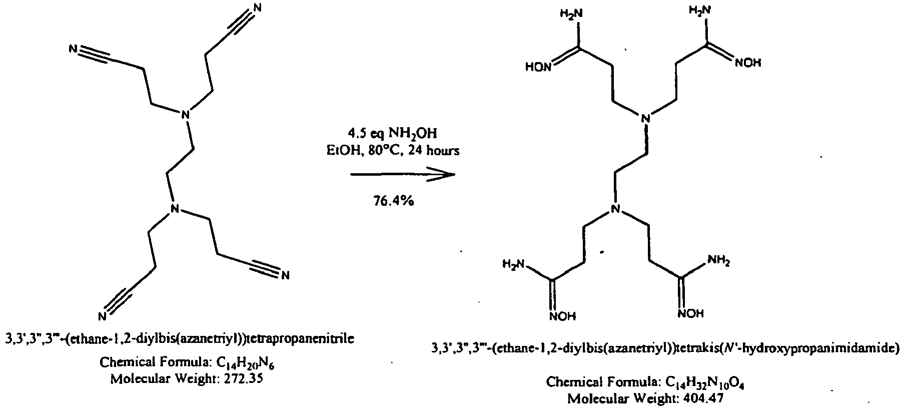

A solution of 3,3',3",3"'-(ethane-1,2-diylbis(azanetriyl))tetrapropanenitrile (1 g, 4 mmol) and NH₂OH (50% in water, 1.1 cm³, 18.1 mmol) in EtOH (10 cm³) was stirred at 80 °C for 24 hours and was then allowed to cool to room temperature. The solid formed was collected by filtration and dried under vacuum to give 3,3',3",3"'-(ethane-1,2-diylbis(azanetriyl))tetrakis(N'-hydroxypropanimidamide) (1.17 g, 76.4%) as a white solid, mp 191-192 °C.

### U) Reaction of 3,3'-(2,2-bis((2-cyanoethoxy)methyl)propane-1,3-diyl)bis(oxy)dipropanenitrile with hydroxylamine to give 3,3'-(2,2-bis((3-(hydroxyamino)-3-iminopropoxy)methyl)propane-1,3-diyl)bis(oxy)bis(N-hydroxypropanimidamide)

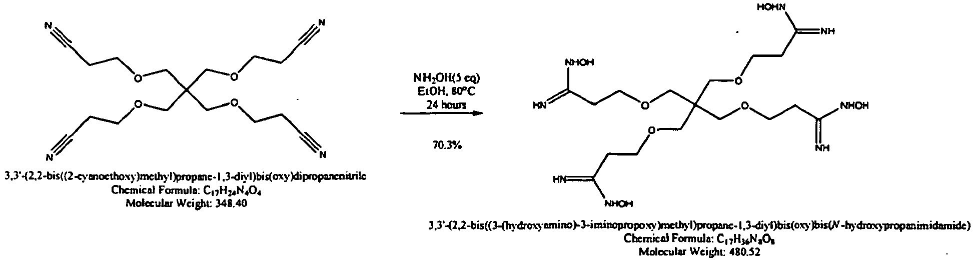

To a solution of 3,3'-(2,2-bis((2-cyanoethoxy)methyl)propane-1,3-diyl)bis(oxy)dipropanenitrile (1 g, 2.9 mmol) in EtOH (10 ml) was added NH₂OH (50% in water, 0.88 ml, 0.948 g, 14.4 mmol), the mixture was stirred at 80 °C for 24 hours and was then cooled to room temperature. Evaporation of the solvent and excess NH₂OH in the rotary evaporator followed by high vacuum for 12 hours gave 3,3'-(2,2-bis((3-(hydroxyamino)-3-iminopropoxy)methyl)propane-1,3-diyl)bis(oxy)bis(N-hydroxypropanimidamide) (0.98 g, 70.3%) as a white solid, mp 60 °C.

### V) Reaction of 3,3'-(2-cyanophenylazanediyl)dipropanenitrile with hydroxylamine to give 3,3'-(2-(N'-hydroxycarbamimidoyl)phenylazanediyl)bis(N'-hydroxypropanimidamide)

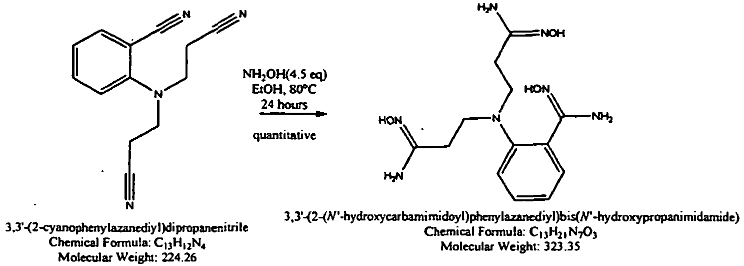

Treatment of 3,3'-(2-cyanophenylazanediyl)dipropanenitrile (1 g, 4.46 mmol) with NH₂OH (1.23 ml, 20 mmol) in EtOH (10 ml) gave a crude product that was triturated with CH₂Cl₂ to give 3,3'-(2-(N'-hydroxycarbamimidoyl)phenylazanediyl)bis(N'-hydroxypropanimidamide) (1.44 g, 100%) as a solid, decomposed 81 °C.

### W) Reaction of N,N-bis(2-cyanoethyl)acetamide with hydroxylamine to give N,N-bis(3-amino-3-(hydroxyimino)propyl)acetamide

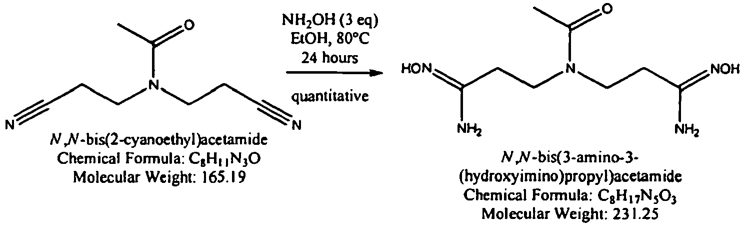

Treatment of N,N-bis(2-cyanoethyl)acetamide (0.5 g, 3.03 mmol) with NH₂OH (0.56 ml, 9.1 mmol) in EtOH (5 ml) gave N,N-bis(3-amino-3-(hydroxyimino)propyl)acetamide (0.564 g, 100%) as a white solid, mp 56.4-58 °C.

### X) Reaction of 3,3'-(2,2'-(methylazanediyl)bis(ethane-2,1-diyl)bis(oxy))dipropanenitrile with hydroxylamine to give 3,3'-(2,2'-(methylazanediyl)bis(ethane-2,1-diyl)bis(oxy))bis(N'-hydroxypropanimidamide)

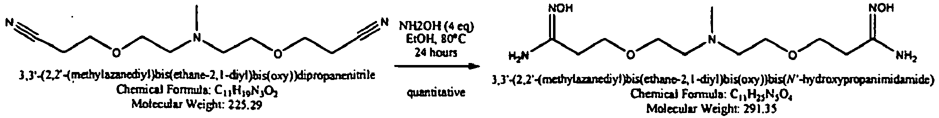

Treatment of 3,3'-(2,2'-(methylazanediyl)bis(ethane-2,1-diyl)bis(oxy))dipropanenitrile (1 g, 4.4 mmol) with NH₂OH (0.82 ml, 13.3 mmol) in EtOH (10 ml) gave 3,3'-(2,2'-(methylazanediyl)bis(ethane-2,1-diyl)bis(oxy))bis(N'-hydroxypropanimidamide) (1.28 g, 100%) as an oil.

### Y) Reaction of glycol derivative 3,3'-(ethane-1,2-diylbis(oxy))dipropanenitrile

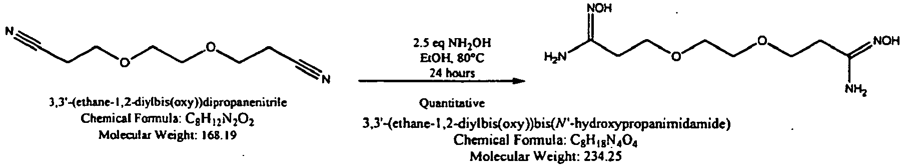

A solution of 3,3'-(ethane-1,2-diylbis(oxy))dipropanenitrile (1 g, 5 mmol) and NH₂OH (50% in water, 0.77 cm³, 12.5 mmol) in EtOH (10 cm³) was stirred at 80 °C for 24 hours and then at room temperature for 24 hours. The solvent and excess NH₂OH were evaporated off and the residue was freeze-dried to give 3,3'-(ethane-1,2-diylbis(oxy))bis(N'-hydroxypropanimidamide) (1.33g, 100%) as a viscous oil.

### Z) Reaction of 3,3'-(piperazine-1,4-diyl)dipropanenitrile

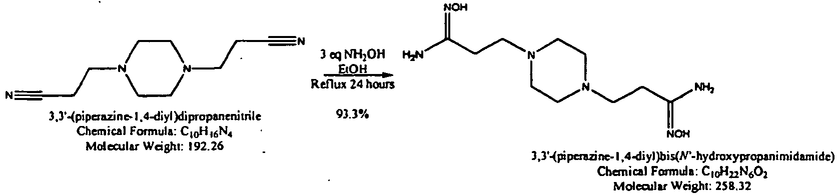

A solution of 3,3'-(piperazine-1,4-diyl)dipropanenitrile (1 g, 5.2 mmol) and NH₂OH (50% in water, 0.96 cm³, 15.6 mmol) in EtOH (10 cm³) were heated to reflux for 24 hours, after which the mixture was allowed to cool to room temperature. The solid formed was collected by filtration and dried in high vacuum line to give 3,3'-(piperazine-1,4-diyl)bis(N'-hydroxypropanimidamide) (1.25 g, 93.3%) as a white solid, decp 238 °C (brown colouration at >220 °C).

### AA) Reaction of cyanoethylated sorbitol compound with hydroxylamine to give 1,2,3,4,5,6-hexakis-4-[3-(hydroxyamino)-3-iminopropyl Hexitol

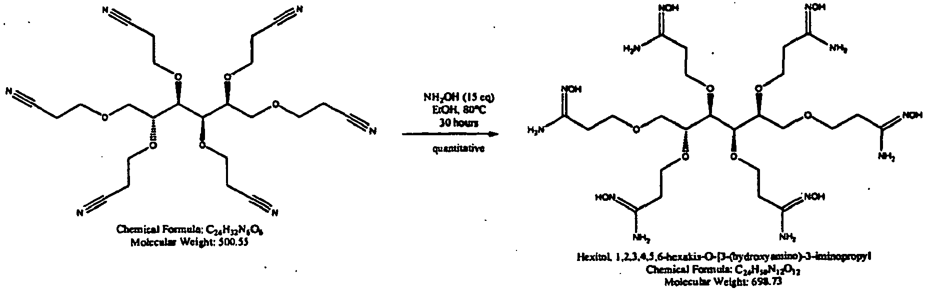

A solution of cyanoethylated product of sorbitol (0.48 g, 0.96 mmol) and NH₂OH (50% in water, 0.41 ml, 0.44 g, 6.71 mmol) in EtOH (5 ml) was stirred at 80 °C for 24 hours. Evaporation of solvent and NMR analysis of the residue showed incomplete conversion. The product was dissolved in water (10 ml) and EtOH (100 ml) and NH₂OH (0.5 g, 7.6 mmol) was added. The mixture was stirred at 80 °C for a further 7 hours. Removal of all volatiles after the reaction gave 1,2,3,4,5,6-hexakis-O-[3-(hydroxyamino)-3-iminopropyl Hexitol, (0.67 g, 100%) as a white solid, mp 92-94 °C (decomposed).

### AG) Reaction of phthalonitrile

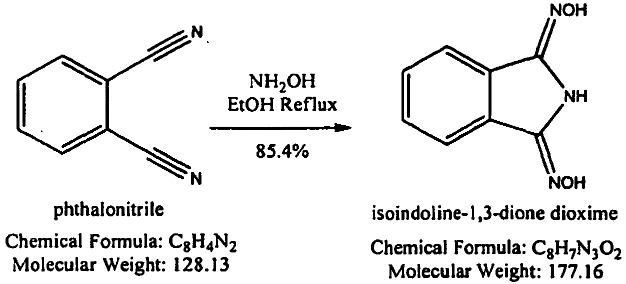

Phthalonitrile (1 g, 7.8 mmol) and hydroxylamine (1.9 cm³, 31.2 mmol, 4 eq) in EtOH (25 cm³) were stirred under reflux for 60 hours, after which the volatiles were removed under reduced pressure and the residue was washed with EtOH (2 cm³) and CH₂Cl₂ (2 cm³) to give the cyclised product isoindoline-1,3-dione dioxime (1.18 g, 85.4%) as a pale yellow solid, mp 272-275 °C (decomposed) (lit 271 °C).

## Claims

1. A semiconductor processing composition comprising at least one compound containing two or more amidoxime functional groups.

2. The semiconductor processing composition of claim 1, wherein the amidoxime compound is selected from the group consisting of 1,2,3,4,5,6-hexakis-O-[3-(hydroxyamino)-3-iminopropyil hexitol, 3,3',3",3"'-(ethane-1,2-diylbis(azanetriyl))tetrakis(N'-hydroxypropanimidamide), 3,3'-(ethane-1,2-diylbis(oxy))bis(N'-hydroxypropanimidamide), 3,3'-(piperazine-1,4-diyl)bis(N'-hydroxypropanimidamide), 3,3',3"-nitrilotris(N'-hydroxypropanimidamide), 3,3'-(2,2-bis((3-(hydroxyamino)-3-iminopropoxy)methyl)propane-1,3-diyl)bis(oxy)bis(N-hydroxypropanimidamide), 3,3'-(2,2'-(methylazanediyl)bis(ethane-2,1-diyl)bis(oxy))bis(N'-hydroxypropanimidamide), N,N-bis(3-amino-3-(hydroxyimino)propyl)acetamide, 3,3'-(2-(N'-hydroxycarbamimidoyl)phenylazanediyl)bis(N'-hydroxypropanimidamide), 3,3'-(2,2'-(3-amino-3-(hydroxyimino)propylazanediyl)bis(ethane-2,1-diyl))bis(oxy)bis(N'-hydroxypropanimidamide), 3,3'-azanediylbis(N'-hydroxypropanimidamide), N'¹,N'⁶-dihydroxyadipimidamide, N'¹,N'¹⁰-dihydroxydecanebis(imidamide), and mixtures thereof.

3. The composition of claim 1, wherein the composition is aqueous.

4. A semiconductor processing composition comprising at least one dendrimer comprising two or more amidoxime functional groups.

5. A process for manufacturing a semiconductor device, the process comprising treating a substrate with a semiconductor processing composition according to any one of the previous claims.

6. The use of a semiconductor processing composition of any one of the previous claims in semiconductor processing.

## Patentansprüche

1. Halbleiterbearbeitungszusammensetzung, die mindestens eine Verbindung umfasst, die zwei oder mehr amidoximfunktionelle Gruppen enthält.

2. Halbleiterbearbeitungszusammensetzung nach Anspruch 1, wobei die Amidoximverbindung aus der Gruppe bestehend aus 1,2,3,4,5,6-Hexakis-O-[3-(hydroxyamino)-3-iminopropyl]hexitol, 3,3',3",3"'-(Ethan-1,2-diylbis(azantriyl))tetrakis(N'-hydroxypropanimidamid), 3,3'-(Ethan-1,2-diylbis(oxy))bis(N'-hydroxypropanimidamid), 3,3'-(Piperazin-1,4-diyl)bis(N'-hydroxypropanimidamid), 3,3',3"-Nitrilotris(N'-hydroxypropanimidamid), 3,3'-(2,2-Bis((3-(hydroxyamino)-3-iminopropoxy)methyl)propan-1,3-diyl)bis(oxy)bis(N-hydroxypropanimidamid), 3,3'-(2,2'-(Methylazandiyl)bis(ethan-2,1-diyl)bis(oxy))bis(N'-hydroxypropanimidamid), N,N-Bis-(3-amino-3-(hydroxyimino)propyl)acetamid, 3,3'-(2-(N'-Hydroxycarbamimidoyl)phenylazandiyl)bis(N'-hydroxypropanimidamid), 3,3'-(2,2'-(3-Amino-3-(hydroxyimino)propylazandiyl)bis(ethan-2,1-diyl))bis(oxy)bis(N'-hydroxypropanimidamid, 3,3'-Azandiylbis(N'-hydroxypropanimidamid), N'¹,N'⁶-Dihydroxyadipimidamid, N'¹,N'¹⁰-Dihydroxydecanbis(imidamid) und Gemischen davon ausgewählt ist.

3. Zusammensetzung nach Anspruch 1, wobei die Zusammensetzung wässrig ist.

4. Halbleiterbearbeitungszusammensetzung, die mindestens ein Dendrimer umfasst, das zwei oder mehr amidoximfunktionelle Gruppen umfasst.

5. Verfahren zur Herstellung eines Halbleiterbauelements, wobei das Verfahren das Behandeln eines Substrats mit einer Halbleiterbearbeitungszusammensetzung nach einem der vorherigen Ansprüche umfasst.

6. Verwendung einer Halbleiterbearbeitungszusammensetzung nach einem der vorherigen Ansprüche bei der Halbleiterbearbeitung.

## Revendications

1. Composition de traitement de semi-conducteur comprenant au moins un composé contenant deux groupements fonctionnels amidoxime ou plus.

2. Composition de traitement de semi-conducteur selon la revendication 1, dans laquelle le composé d'amidoxime est choisi dans le groupe constitué des composés suivants : 1,2,3,4,5,6-hexakis-O-[3-(hydroxyamino)-3-iminopropyl]hexitol, 3,3',3'', 3'''-(éthane-1,2-diylbis(azanétriyl))tétrakis(N'-hydroxypropanimidamide), 3,3'-(éthane-1,2-diylbis-(oxy))bis(N'-hydroxypropanimidamide), 3,3'-(pipérazine-1,4-diyl)bis(N'-hydroxypropanimido-amide), 3,3',3''-nitrilotris(N'-hydroxypropanimidamide), 3,3'-(2,2-bis((3-(hydroxyamino)-3-iminopropoxy)méthyl)propane-1,3-diyl)bis(oxy)-bis(N-hydroxypropanimidamide), 3,3'-(2,2'-(méthyl-azanediyl)bis(éthane-2,1-diyl)bis(oxy))bis(N'-hydroxypropanimidamide), N,N-bis(3-amino-3-(hydroxyimino)propyl)acétamide, 3,3'-(2-(N'-hydroxycarbamimidoyl)phénylazanediyl)bis(N'-hydroxypropanimidamide), 3,3'-(2,2'-(3-amino-3-(hydroxyimino)propylazanediyl)bis(éthane-2,1-diyl))bis(oxy)bis(N'-hydroxypropanimidamide), 3,3'-azanediylbis(N'-hydroxypropanimidamide), N'¹, N'⁶-dihydroxyadipimidamide, N'¹,N'¹⁰-dihydroxy-décanebis(imidamide) et leurs mélanges.

3. Composition selon la revendication 1, dans laquelle la composition est aqueuse.

4. Composition de traitement de semi-conducteur comprenant au moins un dendrimère comprenant deux groupements fonctionnels amidoxime ou plus.

5. Procédé de fabrication d'un dispositif semi-conducteur, le procédé comprenant le traitement d'un substrat avec une composition de traitement de semi-conducteur selon l'une quelconque des revendications précédentes.

6. Utilisation d'une composition de traitement de semi-conducteur selon l'une quelconque des revendications précédentes dans le traitement d'un semi-conducteur.
